# EUROPEAN PATENT SPECIFICATION

(11) **EP 3 943 974 B1**
(45) Date of publication and mention of the grant of the patent: **16.10.2024**
(21) Application number: 19919676.7
(22) Date of filing: 20.06.2019
(51) Int. Cl.: G01S 7/484, G01J 1/02, G01S 17/894, G06V 10/14, G06V 40/16, H01S 5/02345, H01S 5/42, H01S 5/0683, H01S 5/183, G01B 11/24

(54) **LIGHT-EMITTING DEVICE, OPTICAL DEVICE, AND INFORMATION PROCESSING DEVICE**
LICHTEMITTIERENDE VORRICHTUNG, OPTISCHE VORRICHTUNG UND INFORMATIONSVERARBEITUNGSVORRICHTUNG
DISPOSITIF ÉLECTROLUMINESCENT, DISPOSITIF OPTIQUE ET DISPOSITIF DE TRAITEMENT D'INFORMATIONS

(30) Priority: 20.03.2019 JP 2019053386
(43) Date of publication of application: 26.01.2022
(73) Proprietor: Fujifilm Business Innovation Corp., Tokyo 107-0052 (JP)
(72) Inventor: MINAMIRU, Takeshi, Ebina-shi, Kanagawa 243-0494 (JP); SAKAI, Kazuhiro, Ebina-shi, Kanagawa 243-0494 (JP); IGUCHI, Daisuke, Ebina-shi, Kanagawa 243-0494 (JP)
(74) Representative: Haseltine Lake Kempner LLP
(86) International application number: PCT/JP2019/024548
(87) International publication number: WO 2020/188837

(56) References cited:
- EP-A1- 3 413 411
- EP-A2- 2 610 978
- WO-A1-2019/039312
- JP-A- 2005 127 972
- JP-A- 2012 021 884
- JP-A- H10 246 610
- US-A1- 2005 100 345
- US-A1- 2016 182 886

## Description

### TECHNICAL FIELD

The present invention relates to a light-emitting device, an optical device, and an information processing device.

### BACKGROUND ART

Patent Document 1 discloses an imaging device including: a light source; a light diffusing member that has plural lenses arranged adjacent to each other on a predetermined plane and diffuses light emitted from the light source; and an imaging element that receives reflected light obtained by reflecting the light diffused by the light diffusing member by a subject. The plural lenses are arranged such that a period of interference fringes in the diffused light is three pixels or less. US 2005/1 00345 A1 shows a light emitting device with a wiring substrate and a base member which is supposed to be "the base of chip 10". Light sources 12 are mounted on the base member. EP 3 413 411 A1 shows a light emitting device with a wiring substrate 501. A light source (laser) is mounted on the base member, wherein layers are interposed between the light source and the base member. WO 2019/039312 A1 discloses a substrate arrangement. EP 2 610 978 A2 contains more background information concerning the field of the invention.

### PRIOR ART DOCUMENT

### PATENT DOCUMENT

Patent document 1: JP-A-2018-54769

### SUMMARY OF THE INVENTION

### PROBLEM TO BE SOLVED BY THE INVENTION

When it is desired to reduce inductance of a circuit that drives a light source, a wiring such as a bonding wire may be provided not only on one side surface side of the light source but also on plural side surface sides. In addition, a circuit element such as a light receiving element that detects an amount of light emitted from the light source may be disposed close to a side surface of the light source.

In such a case, a configuration is conceivable in which a circuit element is disposed on a drive unit side of the light source, and a wiring such as a bonding wire is provided on another side surface side. However, when the circuit element is disposed between the light source and the drive unit, a path of a wiring pattern that connects the light source and the drive unit is restricted, and the inductance of the circuit may increase.

At least one embodiment of the present invention provides a light-emitting device or the like having a structure in which a path of a wiring pattern is less likely to be restricted by a circuit element in a configuration in which the circuit element is disposed between a light source and a drive unit, as compared with a configuration in which a wiring pattern connecting a light source and a drive unit and a circuit element are both provided on a wiring substrate.

### MEANS FOR SOLVING THE PROBLEM

The problem is solved by the invention defined in the independent claims.
According to a first aspect of the present invention, there is provided a light-emitting device, including: a wiring substrate; a base member that is mounted on the wiring substrate; a light source that is mounted on the base member; a drive unit that is mounted on the wiring substrate and drives the light source; a wiring pattern that is on the wiring substrate, is connected to the light source and extends from a back surface side of the base member toward the drive unit; and a circuit element that is provided in a region on the front surface of the base member between the light source and the drive unit, the region overlapping the wiring pattern in a plan view, so that a path of the wiring pattern connecting the light source and the drive unit is not restricted by the circuit element.

A second aspect of the present invention is the light-emitting device according to the first aspect, in which the circuit element is electrically connected to the wiring substrate, and the wiring pattern is wired without avoiding a connection portion between the circuit element and the wiring substrate.

A third aspect of the present invention is the light-emitting device according to the first or second aspect, in which the circuit element includes a first electrode and a second electrode, wherein the first electrode and the second electrode are separated on two sides of the circuit element to sandwich a light-source cathode wiring pattern provided on the wiring substrate, and are connected to a circuit element anode wiring pattern and a circuit cathode wiring pattern.

A fourth aspect of the present invention is the light-emitting device according to any one of the first to third aspects, in which the light source is a light-emitting element array that includes a first side surface and a second side surface facing each other, and a third side surface and a fourth side surface facing each other and connecting the first side surface and the second side surface, and a wiring extending from an upper-surface electrode of the light-emitting element array toward an outer side of the light-emitting element array is provided at least at a side of the first side surface and the second side surface, the circuit element is provided on the base member at a side of the fourth side surface, and the wiring pattern extends from the side of the fourth side surface toward the drive unit.

A fifth aspect of the present invention is the light-emitting device according to the fourth aspect, in which the wiring extending from an upper-surface electrode of the light-emitting element array toward an outer side of the light-emitting element array is provided at a side of the third side surface.

A sixth aspect of the present invention is the light-emitting device according to the fourth aspect, in which another circuit element is provided on the base member at a side of the third side surface.

A seventh aspect of the present invention is the light-emitting device according to the sixth aspect, in which at least one of the circuit element and the other circuit element is a light receiving element.

An eighth aspect of the present invention is the light-emitting device according to any one of the first to seventh aspects, in which the base member is a member having a higher thermal conductivity than the wiring substrate.

A ninth aspect of the present invention is the light-emitting device according to the eighth aspect, in which the base member on the wiring substrate is made of ceramic.

A tenth aspect of the present invention is the light-emitting device according to any one of the fourth to seventh aspects, in which a light diffusing member that diffuses, toward an outside, light emitted from the light source is provided on an emission path of the light-emitting element array in the light source.

An eleventh aspect of the present invention is the light-emitting device according to any one of the fourth to seventh aspects, in which the light-emitting element array includes plural light-emitting elements connected in parallel to one another.

According to a twelfth aspect of the present invention, there is provided a light-emitting device including: a wiring substrate; a light source and a drive unit driving the light source that are mounted on the wiring substrate; a wiring pattern that is on the wiring substrate and connects the light source and the drive unit; a base member that is provided across the wiring pattern between the light source and the drive unit; and a circuit element that is provided in a region on the front surface of the base member, the region overlapping the wiring pattern in a plan view, so that a path of the wiring pattern connecting the light source and the drive unit is not restricted by the circuit element.

According to a thirteenth aspect of the present invention, there is provided an optical device including: the light-emitting device according to any one of the first to twelfth aspects; and a light receiving unit that receives reflected light emitted from the light source included in the light-emitting device and reflected by an object to be measured, in which the light receiving unit outputs a signal corresponding to a time from when light is emitted from the light source to when the light is received by the light receiving unit.

According to a fourteenth aspect of the present invention, there is provided an information processing device including: the optical device according to the thirteenth aspect; and a shape specifying unit that specifies a three-dimensional shape of an object to be measured based on reflected light that is emitted from the light source included in the optical device, reflected by the object to be measured, and received by the light receiving unit included in the optical device.

A fifteenth aspect of the present invention is the information processing device according to the fourteenth aspect, further including: an authentication processing unit that performs authentication processing related to use of the information processing device based on a specified result of the shape specifying unit.

### EFFECTS OF INVENTION

According to the invention of the first aspect and the twelfth aspect, a path of a wiring pattern is less likely to be restricted by the circuit element, as compared with a configuration in which the wiring pattern connecting the light source and the drive unit and the circuit element are provided on the wiring substrate.

According to the invention of the second aspect, the path of the wiring pattern is not affected by the connection portion between the circuit element and the wiring substrate.

According to the invention of the third aspect, a size of the light-emitting device is easily reduced as compared with a case where the first electrode and the second electrode are connected to the wiring substrate on one side in the width direction of the wiring pattern.

According to the invention of the fourth aspect, inductance of the circuit is reduced as compared with a case where the wiring extending from the upper-surface electrode toward the outer side is provided only on one side surface side of the light-emitting element array.

According to the invention of the fifth aspect, the inductance of the circuit is reduced as compared with a case where the wiring extending from the upper-surface electrode toward the outer side is provided only on two side surface sides of the light-emitting element array.

According to the invention of the sixth aspect, heat dissipation effect is higher than in a case where other circuit elements are not provided.

According to the invention of the seventh aspect, light emitted from the light source is detected.

According to the invention of the eighth aspect, the heat dissipation effect is higher than in a case where the base member has the same thermal conductivity as the wiring substrate.

According to the invention of the ninth aspect, the heat dissipation effect is higher than in a case where the base member is made of resin.

According to the invention of the tenth aspect, light emitted from the light source is radiated in a wide range as compared with a configuration in which the light diffusing member is not provided.

According to the invention of the eleventh aspect, light of a high intensity is simultaneously radiated as compared with a configuration in which the light-emitting elements are individually driven.

According to the present invention of the thirteenth aspect, there is provided an optical device capable of performing three-dimensional measurement.

According to the present invention of the fourteenth aspect, there is provided an information processing device capable of measuring a three-dimensional shape.

According to the present invention of the fifteenth aspect, there is provided an information processing device loaded with authentication processing based on a three-dimensional shape.

### BRIEF DESCRIPTION OF DRAWINGS

Fig. 1 is a diagram illustrating an example of an information processing device;
Fig. 2 is a block diagram illustrating a configuration of the information processing device;
Fig. 3 is a plan view of a light source;
Fig. 4 is a diagram illustrating a cross-sectional structure of one VCSEL in the light source;
Fig. 5 is a diagram illustrating an example of a light diffusing member, in which (a) included in Fig. 5 is a plan view and (b) included in Fig. 5 is a cross-sectional view taken along a line VB-VB of (a);
Fig. 6 is a diagram illustrating an example of an equivalent circuit that drives a light source by low-side driving;
Fig. 7 is a diagram illustrating a light-emitting device to which a first embodiment of the invention is applied, in which (a) included in Fig. 7 is a plan view, (b) included in Fig. 7 is a cross-sectional view taken along a line VIIB-VIIB of (a), and (c) included in Fig. 7 is a cross-sectional view taken along a line VIIC-VIIC of (a);
Fig. 8 is a diagram illustrating a wiring pattern provided on a wiring substrate and a base member, in which (a) included in Fig. 8 is a front surface of the wiring substrate, (b) included in Fig. 8 is a front surface of the base member, and (c) included in Fig. 8 is a back surface of the base member;
Fig. 9 is a diagram illustrating a relationship in which a PD is provided at an outer side of a light-source cathode wiring pattern in the wiring substrate, in which (a) included in Fig. 9 is a first example and (b) included in Fig. 9 is a second example;
Fig. 10 is a diagram illustrating a light-emitting device of a first comparative example, not part of the claimed invention, in which (a) included in Fig. 10 is a plan view and (b) included in Fig. 10 is a cross-sectional view taken along a line XB-XB of (a);
Fig. 11 is a diagram illustrating a light-emitting device of a second comparative example, not part of the claimed invention, in which (a) included in Fig. 11 is a plan view and (b) included in Fig. 11 is a cross-sectional view taken along a line XIB-XIB of (a);
Fig. 12 is a diagram illustrating a light-emitting device to which a second embodiment of the invention is applied, in which (a) included in Fig. 12 is a plan view, (b) included in Fig. 12 is a cross-sectional view taken along a line XIIB-XIIB of (a), and (c) included in Fig. 12 is a cross-sectional view taken along a line XIIC-XIIC of (a); and
Fig. 13 is a view illustrating a wiring pattern provided on a wiring substrate and a base member, in which (a) included in Fig. 13 is a front surface of the wiring substrate, (b) included in Fig. 13 is a front surface of the base member, and (c) included in Fig. 13 is a back surface of the base member.

### EMBODIMENTS FOR CARRYING OUT THE INVENTION

Hereinafter, embodiments of the present invention will be described in detail with reference to the accompanying drawings.

In many cases, an information processing device identifies whether a user who has accessed the information processing device is permitted to access the information processing device, and permits use of the information processing device that is an own device only when it is authenticated that the user is an user whose access is permitted. A method for authenticating a user by a password, a fingerprint, an iris, or the like has been used so far. Recently, there is a demand for an authentication method having a higher security. Such a method includes performing authentication based on a three-dimensional image such as a shape of a face of a user.

Here, an example in which the information processing device is a portable information processing terminal will be described, and the information processing device authenticates a user by recognizing a shape of a face that is captured as a three-dimensional image. The information processing device can be applied to an information processing device such as a personal computer (PC) other than a portable information processing terminal.

Furthermore, the configuration, function, method, and the like described in the present embodiment can also be applied to recognition of a three-dimensional shape other than recognition of a shape of a face. That is, the present invention may be applied to recognize a shape of an object other than a face. Further, a distance to an object to be measured is not limited.

### [First Embodiment]

### (Information Processing Device 1)

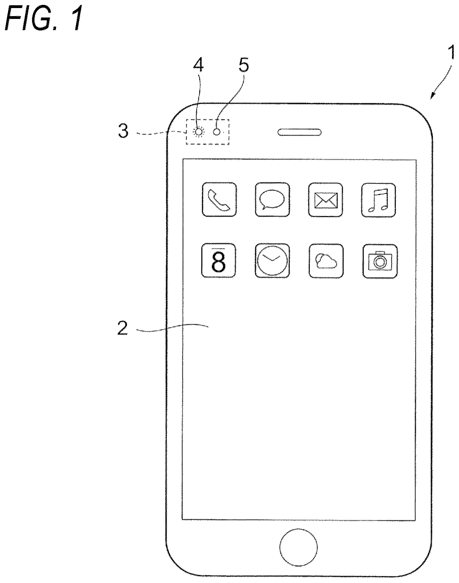

Fig. 1 is a diagram illustrating an example of an information processing device 1. As described above, the information processing device 1 is, for example, a portable information processing terminal.

The information processing device 1 includes a user interface unit (hereinafter, referred to as a UI unit) 2 and an optical device 3 that acquires a three-dimensional image. The UI unit 2 is configured by integrating, for example, a display device that displays information to a user and an input device to which an instruction for information processing is input by an operation of the user. The display device is, for example, a liquid crystal display or an organic EL display, and the input device is, for example, a touch panel.

The optical device 3 includes a light-emitting device 4 and a three-dimensional sensor (hereinafter, referred to as a 3D sensor) 5. The light-emitting device 4 radiates light toward an object to be measured, that is, a face in the example described here, in order to acquire a three-dimensional image thereof. The 3D sensor 5 acquires the light that is radiated by the light-emitting device 4, is reflected by the face, and is returned. Here, the three-dimensional image of the face is acquired based on a so-called time of flight (TOF) method based on flight time of light. Hereinafter, in a case of acquiring a three-dimensional image of a face, the face is referred to as an object to be measured. Note that a three-dimensional image other than that of a face may be acquired. The acquisition of a three-dimensional image may be referred to as 3D sensing. The 3D sensor 5 is an example of a light receiving unit.

The information processing device 1 is configured as a computer including a CPU, a ROM, a RAM, and the like. The ROM includes a non-volatile rewritable memory such as a flash memory. Further, programs and constants stored in the ROM are loaded to the RAM and are executed by the CPU, so that the information processing device 1 is operated and various types of information processing are executed.

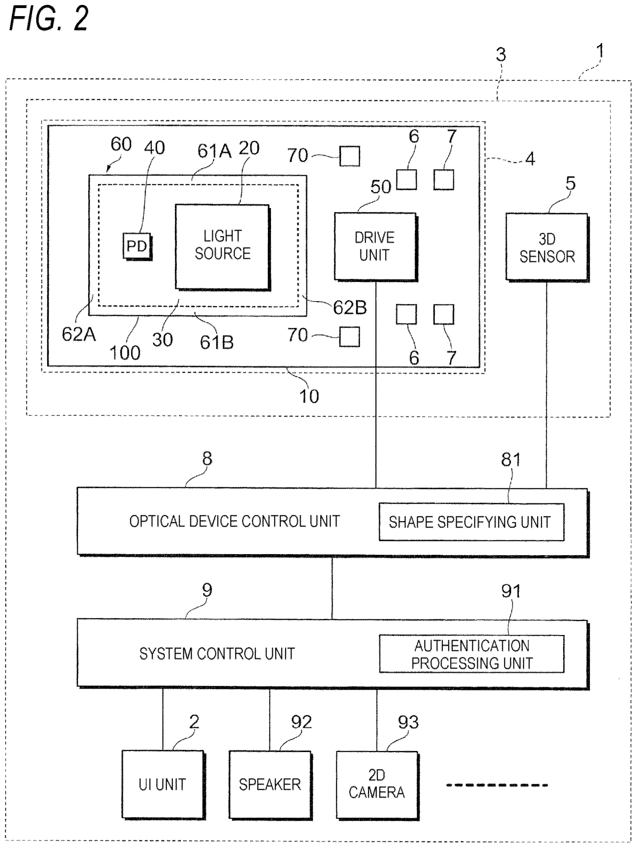

Fig. 2 is a block diagram illustrating a configuration of the information processing device 1.

The information processing device 1 includes the optical device 3 described above, an optical device control unit 8, and a system control unit 9. The optical device control unit 8 controls the optical device 3. The optical device control unit 8 includes a shape specifying unit 81. The system control unit 9 controls the entire information processing device 1 as a system. The system control unit 9 includes an authentication processing unit 91. The UI unit 2, a speaker 92, and a two-dimensional camera (indicated by a 2D camera in Fig. 2) 93, and the like are connected to the system control unit 9.

Hereinafter, the components described above will be described in order.

The light-emitting device 4 included in the optical device 3 includes a wiring substrate 10, a base member 100, a light source 20, a light diffusing member 30, and a light receiving element 40 for monitoring a light amount (indicated by PD in Fig. 2 and the following description), a drive unit 50, a holding portion 60 and a capacitor 70. The light-emitting device 4 further includes passive elements such as a resistor element 6 and a capacitor 7 in order to operate the drive unit 50. Although two capacitors 70 are shown, one capacitor 70 may be provided or more than two capacitors 70 may be provided. Further, a plural resistor elements 6 and plural capacitors 7 may be provided. Here, the capacitor 70, the 3D sensor 5, the resistance element 6, the capacitor 7, and the like other than the light source 20, the PD 40, and the drive unit 50 may be referred to as circuit components without being distinguished from one another.

The light source 20 and the PD 40 are provided on the base member 100. The base member 100 is configured with an electrically insulating member. Further, the base member 100, the drive unit 50, the capacitor 70, the resistor element 6, and the capacitor 7 are provided on the wiring substrate 10.

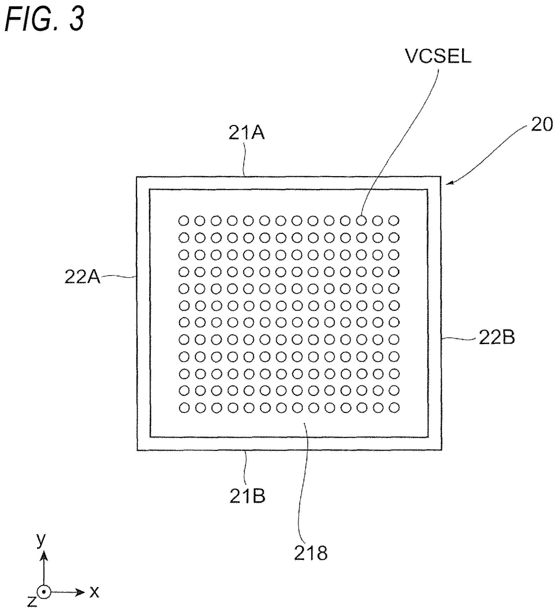

The light source 20 is configured as a light-emitting element array in which plural light-emitting elements are two-dimensionally arranged (see Fig. 3 to be described later). The light-emitting element is, for example, a vertical cavity surface emitting laser element (VCSEL). An example in which the light-emitting element is a vertical cavity surface emitting laser element (VCSEL) will be described in the following description. The vertical cavity surface emitting laser element (VCSEL) is referred to as a VCSEL. The light source 20 emits light in a direction perpendicular to a front surface of the wiring substrate 10 or the base member 100. When performing three-dimensional sensing with a ToF method, the light source 20 is required to be driven by the drive unit 50 to emit pulsed light (hereinafter, referred to as an emitted light pulse) having, for example, 100 MHz or more and a rise time of 1 ns or less. When face authentication is taken as an example, a distance of light radiation is about 10 cm to about 1m. A range in which a 3D shape of an object to be measured is measured is about 1m square. Therefore, the light source 20 is required to have a large output and efficiently dissipate heat generated by the light source 20. A distance of light radiation is referred to as a measurement distance, and a range in which a 3D shape of an object to be measured is measured is referred to as a measurement range or a radiation range. A surface virtually provided in the measurement range or the radiation range is referred to as an irradiation surface.

The PD 40 is a photodiode of a pin-type or the like that outputs an electric signal corresponding to an amount of received light (hereinafter, referred to as a received light amount) and includes a p-type Si region serving as an anode, an i (intrinsic)-type Si region, and an n-type Si region serving as a cathode. An anode electrode is provided in the p-type Si region, and a cathode electrode is provided in the n-type Si region. The PD 40 is an example of a circuit element, the anode electrode is an example of a first electrode, and the cathode electrode is an example of a second electrode.

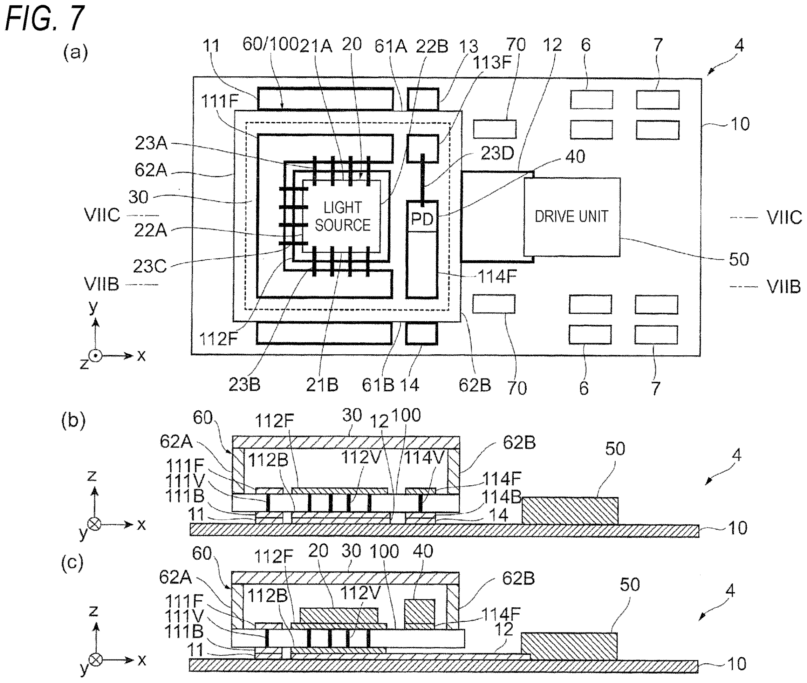

The light diffusing member 30 is provided so as to cover the light source 20 and the PD 40. That is, the light diffusing member 30 is provided at a predetermined distance from the light source 20 and the PD 40 on the base member 100 by the holding portion 60 provided on the base member 100. The light diffusing member 30 covering the light source 20 means that the light diffusing member 30 is provided on an emission path of light emitted from the light source 20 so that the light emitted from the light source 20 is transmitted through the light diffusing member 30. This means a state in which the light source 20 and the PD 40 overlap the light diffusing member 30 in a plan view as will be described later. Here, the plan view refers to a view in a case of viewing in an x-y plane in Fig. 3, (a) of Fig. 7, and the like to be described later. The PD 40 is disposed at a position covered by the light diffusing member 30 so as to receive a part of light reflected by the light diffusing member 30 among light emitted from the light source 20.

The holding portion 60 includes walls 61A, 61B, 62A, and 62B provided so as to surround the light source 20 and the PD 40. Here, it is assumed that an outer shape of the base member 100, an outer shape of the light diffusing member 30, and an outer shape of the holding portion 60 are the same. Therefore, outer edges of the base member 100, the light diffusing member 30, and the holding portion 60 overlap one another. The outer shape of the base member 100 may be larger than the outer shape of the light diffusing member 30 or the outer shape of the holding portion 60.

Details of the wiring substrate 10, the base member 100, the light source 20, the light diffusing member 30, the drive unit 50, and the holding portion 60 in the light-emitting device 4 will be described later.

The 3D sensor 5 includes plural light receiving cells. For example, each light receiving cell is configured to receive pulsed reflected light (hereinafter, referred to as a received light pulse) from an object to be measured to which an emitted light pulse from the light source 20 is emitted, and accumulate electric charges corresponding to a time until the light receiving cell receives the pulsed reflected light for each light receiving cell. The 3D sensor 5 is configured as a device having a CMOS structure in which each light receiving cell includes two gates and two charge accumulating units corresponding to the gates. Then, generated photoelectrons are transferred to any one of the two charge accumulating units at high speed by alternately applying pulses to the two gates. Charges corresponding to a phase difference between the emitted light pulse and the received light pulse are accumulated in the two charge accumulating units. Then, the 3D sensor 5 outputs, as a signal, a digital value corresponding to the phase difference between the emitted light pulse and the received light pulse for each light receiving cell via an AD converter. That is, the 3D sensor 5 outputs a signal corresponding to a time from when light is emitted from the light source 20 to when the light is received by the 3D sensor 5. The AD converter may be provided in the 3D sensor 5 or may be provided outside the 3D sensor 5.

As described above, when face authentication is taken as an example, the light source 20 is required to emit light in an irradiation range of about 1m square at a distance of about 10 cm to about 1m. The 3D sensor 5 receives reflected light from the object to be measured to measure a 3D shape of the object to be measured. Therefore, the light source 20 is required to have a large output. Therefore, it is required to efficiently dissipate heat from the light source 20.

The shape specifying unit 81 of the optical device control unit 8 acquires, from the 3D sensor 5, the digital value obtained for each light receiving cell, and calculates a distance to the object to be measured for each light receiving cell. Further, the 3D shape of the object to be measured is specified based on the calculated distances.

The authentication processing unit 91 of the system control unit 9 performs authentication processing related to use of the information processing device 1 when the 3D shape of the object to be measured that is a specification result specified by the shape specifying unit 81 is a 3D shape stored in advance in the ROM or the like. The authentication processing related to use of the information processing device 1 is, for example, a processing of determining whether to permit the use of the information processing device 1 that is an own device. For example, when it is determined that a 3D shape of a face that is the object to be measured coincides with a face shape stored in a storage member such as the ROM, the use of the information processing device 1 including various applications provided by the information processing device 1 is permitted.

The shape specifying unit 81 and the authentication processing unit 91 are configured with, for example, a program. In addition, the shape specifying unit 81 and the authentication processing unit 91 may be configured with an integrated circuit such as an ASIC or an FPGA. Further, the shape specifying unit 81 and the authentication processing unit 91 may be configured with software such as a program and an integrated circuit such as an ASIC.

In Fig. 2, the optical device 3, the optical device control unit 8, and the system control unit 9 are shown to be separated from each other. Alternatively, the system control unit 9 may include the optical device control unit 8. The optical device control unit 8 may be included in the optical device 3. Further, the optical device 3, the optical device control unit 8, and the system control unit 9 may be integrated.

Next, before describing the light-emitting device 4, the light source 20, the light diffusing member 30, the drive unit 50, and the capacitor 70 constituting the light-emitting device 4 will be described.

### (Configuration of Light Source 20)

Fig. 3 is a plan view of the light source 20. The light source 20 includes plural VCSELs arranged in a two-dimensional array. That is, the light source 20 is configured as a light-emitting element array in which a VCSEL serves as a light-emitting element array. A right direction of a paper surface is defined as an x direction, and an upper direction of the paper surface is defined as a y direction. A direction orthogonal to the x direction and the y direction in a counterclockwise manner is defined as a z direction. The x, y, and z directions in the drawings are the same. A front surface refers to a surface at a +z direction side, and a back surface refers to a surface at a -z direction side. The same applies to the other cases.

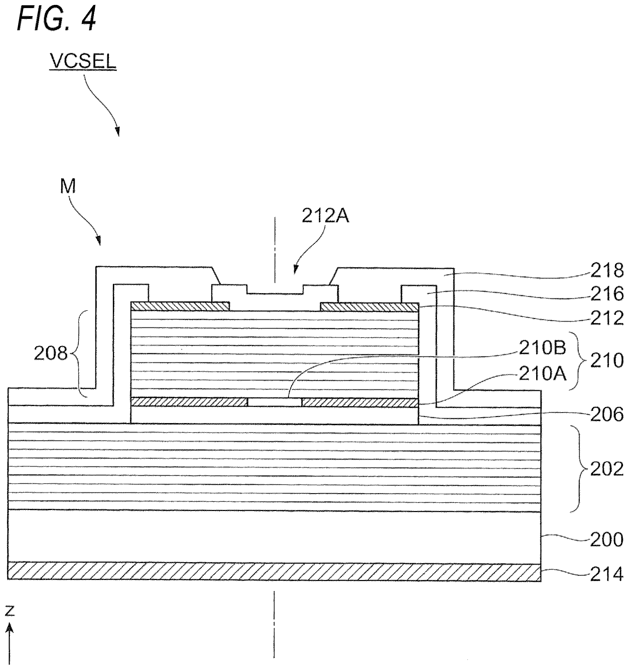

The VCSEL is a light-emitting element in which an active region serving as a light-emitting region is provided between a lower multilayer film reflector and an upper multilayer film reflector that are stacked on a semiconductor substrate 200 (see Fig. 4 to be described later), and laser light is emitted in a direction perpendicular to the semiconductor substrate 200. Therefore, it is easy to form a two-dimensional array. The number of VCSELs included in the light source 20 is, for example, 100 to 1000. The plural VCSELs are connected to one another in parallel and are driven in parallel. The number of VCSELs described above is an example, and may be set according to a measurement distance or a measurement range.

An anode electrode 218 (see Fig. 4 to be described later) shared by the plural VCSELs is provided on a front surface of the light source 20. A cathode electrode 214 is provided on a back surface of the light source 20 (see Fig. 4 to be described later). That is, the plural VCSELs are connected in parallel. When plural VCSELs are connected and driven in parallel, light having a strong intensity is simultaneously emitted and is radiated onto the object to be measured, as compared with a case where the VCSELs are individually driven.

Here, it is assumed that a planar shape of the light source 20, which is a shape in a plan view, is a quadrangle. A side surface on a +y direction side is denoted as a side surface 21A, a side surface on a -y direction side is denoted as a side surface 21B, a side surface on a -x direction side is denoted as a side surface 22A, and a side surface on a +x direction side is denoted as a side surface 22B. The side surface 21A and the side surface 21B face each other. The side surface 22A and the side surface 22B are each continuous with the side surface 21A and the side surface 21B, and face each other. Here, the side surface 21A is an example of a first side surface, the side surface 21B is an example of a second side surface, the side surface 22A is an example of a third side surface, and the side surface 22B is an example of a fourth side surface.

### (Structure of VCSEL)

Fig. 4 is a diagram illustrating a cross-sectional structure of one VCSEL in the light source 20. The VCSEL is a VCSEL having a λ cavity structure. An upper direction of the paper surface is defined as a z direction.

The VCSEL is implemented by sequentially stacking, on the semiconductor substrate 200 such as an n-type GaAs substrate, an n-type lower distributed Bragg reflector (DBR) 202 in which AlGaAs layers having different Al compositions are alternately stacked, an active region 206 including a quantum well layer that is interposed between an upper spacer layer and a lower spacer layer, and a p-type upper distributed Bragg reflector 208 in which AlGaAs layers having different Al compositions are alternately stacked. Hereinafter, the distributed Bragg reflector is referred to as a DBR.

The n-type lower DBR 202 is a stacked body in which an Al_{0.9}Ga_{0.1}As layer and a GaAs layer are paired, and a thickness of each layer is λ/4nᵣ (in which λ is an oscillation wavelength and nᵣ is a refractive index of a medium), and these layers are alternately stacked in 40 cycles. A carrier concentration after doping with silicon that is an n-type impurity, is, for example, 3 × 10¹⁸ cm⁻³.

The active region 206 is formed by stacking a lower spacer layer, a quantum well active layer, and an upper spacer layer. For example, the lower spacer layer is an undoped Al_{0.6}Ga_{0.4}As layer, the quantum well active layer is an undoped InGaAs quantum well layer and an undoped GaAs barrier layer, and the upper spacer layer is an undoped Al_{0.6}Ga_{0.4}As layer.

The p-type upper DBR 208 is a stacked body in which a p-type Al_{0.9}Ga_{0.1}As layer and a GaAs layer are paired, a thickness of each layer is λ/4nᵣ, and these layers are alternately stacked in 29 cycles. A carrier concentration after doping with carbon that is a p-type impurity is, for example, 3 × 10¹⁸ cm⁻³. Preferably, a contact layer formed of p-type GaAs is formed on an uppermost layer of the upper DBR 208, and a current confinement layer 210 formed of p-type AlAs is formed to be a lowermost layer of the upper DBR 208 or inside the upper DBR 208.

A cylindrical mesa M is formed on the semiconductor substrate 200 by etching stacked semiconductor layers from the upper DBR 208 to the lower DBR 202. Accordingly, the current confinement layer 210 is exposed at a side surface of the mesa M. An oxidized region 210A oxidized from the side surface of the mesa M and a conductive region 210B surrounded by the oxidized region 210A are formed in the current confinement layer 210 by an oxidation process. In the oxidation process, an AlAs layer has a higher oxidation rate than an AlGaAs layer, and the oxidized region 210A is oxidized from the side surface of the mesa M toward an inner side at a substantially constant rate, so that a planar shape of the conductive region 210B is a shape that reflects an outer shape of the mesa M, that is, a circular shape, and a center of the conductive region 210B substantially coincides with an axial direction (dashed-dotted line) of the mesa M. The mesa M has a columnar structure in the present embodiment.

An annular p-side electrode 212 that is formed of metal and in which Ti/Au or the like is stacked is formed on an uppermost layer of the mesa M. The p-side electrode 212 is in ohmic contact with a contact layer of the upper DBR 208. An inner side of the annular p-side electrode 212 defines a light emission port 212A through which laser light is emitted to an outside. That is, in the VCSEL, light is emitted in a direction perpendicular to the semiconductor substrate 200, and the axial direction of the mesa M serves as an optical axis. Further, the cathode electrode 214 is formed on a back surface of the semiconductor substrate 200 as an n-side electrode. A front surface of the upper DBR 208 on the inner side of the p-side electrode 212 is a light-emitting surface. That is, an optical axis direction of the VCSEL is a light emitting direction.

An insulating layer 216 is provided in a manner of covering a front surface of the mesa M except for a portion of the p-side electrode 212 to which an anode electrode (the anode electrode 218 to be described later) is connected and the light emission port 212A. The anode electrode 218 is provided to be in ohmic contact with the p-side electrode 212 except for the light emission port 212A. The anode electrode 218 is shared by the plural VCSELs. That is, in the plural VCSELs constituting the light source 20, the p-side electrodes 212 thereof are connected in parallel by the anode electrode 218. The anode electrode 218 is an example of an upper surface electrode of the light-emitting element array.

The VCSEL may oscillate in a single transverse mode or in a multiple transverse mode. For example, an optical output of one VCSEL is 4 mW to 8 mW. Therefore, for example, when the light source 20 includes 500 VCSELs, an optical output of the light source 20 is 2W to 4W. In the light source 20 having such a large output, heat generated by the light source 20 is large.

### (Configuration of Light Diffusing Member 30)

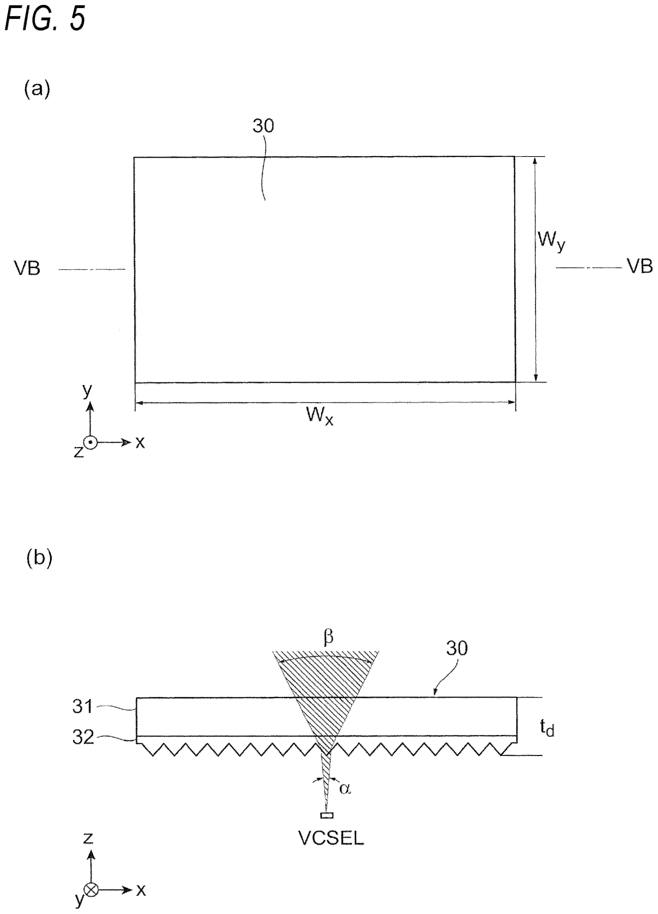

Fig. 5 is a diagram illustrating an example of the light diffusing member 30. (a) of Fig. 5 is a plan view and (b) of Fig. 5 is a cross-sectional view taken along a line VB-VB in (a) of Fig. 5. In (a) of Fig. 5, a right direction of a paper surface is defined as the x direction, an upper direction of the paper surface is defined as the y direction. A direction orthogonal to the x direction and the y direction in a counterclockwise manner is defined as the z direction. In (b) of Fig. 5, a right direction of the paper surface is defined as the x direction, and an upper direction of the paper surface is defined as the z direction.

As illustrated in (b) of Fig. 5, the light diffusing member 30 includes a resin layer 32 formed with unevenness for diffusing light onto a back surface of a flat glass base member 31 of which two surfaces are parallel to each other. The light diffusing member 30 further expands a spread angle of light incident from the VCSEL of the light source 20 and emits the light. That is, the unevenness formed in the resin layer 32 of the light diffusing member 30 refracts or scatters light to increase a spread angle α of incident light to a larger spread angle β of emitted light. That is, as illustrated in Fig. 5, the spread angle β of light that is transmitted through the light diffusing member 30 and is emitted from the light diffusing member 30 is larger than the spread angle α of the light emitted from the VCSEL (α < β). Therefore, when the light diffusing member 30 is used, area of an irradiation surface irradiated with the light emitted from the light source 20 is increased as compared with a case where the light diffusing member 30 is not used. In addition, a light density on the irradiation surface is reduced. The light density refers to irradiance per unit area, and the spread angles α and β are full widths at half maximum (FWHM).

A planar shape of the light diffusing member 30 is, for example, a quadrangle. A width Wₓ of the light diffusing member 30 in the x direction and a vertical width W_{y} of the light diffusing member 30 in the y direction is 1 mm to 10 mm, and a thickness td of the light diffusing member 30 in the z direction is 0.1 mm to 1 mm. When the light diffusing member 30 has a size and a shape as described above, in particular, a light diffusing member suitable for face authentication of a portable information processing terminal or measurement at a relatively short distance of about several meters is provided. The planar shape of the light diffusing member 30 may be another shape such as a polygon or a circle.

### (Drive Unit 50 and Capacitor 70)

When it is desired to drive the light source 20 at a higher speed, it is preferable to perform low-side driving. The low-side driving refers to a configuration in which a drive element such as an MOS transistor is positioned on a downstream side of a current path relative to a drive target such as a VCSEL. Conversely, a configuration in which a drive element is positioned on an upstream side is referred to as high-side driving.

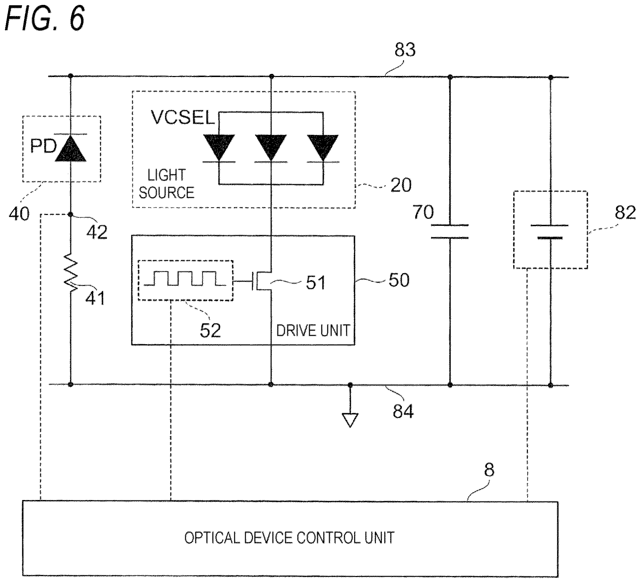

Fig. 6 is a diagram illustrating an example of an equivalent circuit that drives the light source 20 by low-side driving. In Fig. 6, the VCSEL of the light source 20, the drive unit 50, the capacitor 70, a power supply 82, the PD 40, and a detection resistor element 41 that detects a current flowing through the PD 40 are illustrated.

The power supply 82 is provided in the optical device control unit 8 illustrated in Fig. 2. The power supply 82 generates a direct current voltage having a positive side as a power supply potential and a negative side as a ground potential. The power supply potential is supplied to a power supply line 83, and the ground potential is supplied to a ground line 84.

As described above, the light source 20 is configured by connecting plural VCSELs in parallel. The anode electrode 218 (see Fig. 4) of the VCSEL is connected to the power supply line 83.

The drive unit 50 includes an n-channel MOS transistor 51 and a signal generation circuit 52 that turns on and turns off the MOS transistor 51. A drain of the MOS transistor 51 is connected to the cathode electrode 214 (see Fig. 4) of the VCSEL. A source of the MOS transistor 51 is connected to the ground line 84. A gate of the MOS transistor 51 is connected to the signal generation circuit 52. That is, the VCSEL and the MOS transistor 51 of the drive unit 50 are connected in series between the power supply line 83 and the ground line 84. The signal generation circuit 52 generates an "H level" signal for setting the MOS transistor 51 to an ON state and an "L level" signal for setting the MOS transistor 51 to an OFF state under the control of the optical device control unit 8.

The capacitor 70 has one terminal connected to the power supply line 83 and the other terminal connected to the ground line 84. When there are plural capacitors 70, the plural capacitors 70 are connected in parallel. The capacitor 70 is an electrolytic capacitor, a ceramic capacitor, or the like.

The PD 40 has a cathode electrode connected to the power supply line 83 and an anode electrode connected to one terminal of the detection resistor element 41. The other terminal of the detection resistor element 41 is connected to the ground line 84. That is, the PD 40 and the detection resistor element 41 are connected in series between the power supply line 83 and the ground line 84. An output terminal 42, which is a connection point between the PD 40 and the detection resistor element 41, is connected to the optical device control unit 8.

Next, a method of driving the light source 20 that is low-side driving will be described.

First, it is assumed that a signal generated by the signal generation circuit 52 in the drive unit 50 is at an "L level". In this case, the MOS transistor 51 is in an OFF state. That is, no current flows between the source and the drain of the MOS transistor 51. Therefore, no current flows through the VCSEL connected in series with the MOS transistor 51. The VCSEL does not emit light.

At this time, the capacitor 70 is charged by the power supply 82. That is, one terminal of the capacitor 70 connected to the power supply line 83 is a power supply potential, and the other terminal of the capacitor 70 connected to the ground line 84 is a ground potential. The capacitor 70 accumulates electric charges determined by a capacitance, a power supply voltage (= power supply potential - ground potential), and time.

Next, when a signal generated by the signal generation circuit 52 in the drive unit 50 is at an "H level", the MOS transistor 51 shifts from an OFF state to an ON state. Then, the electric charges accumulated in the capacitor 70 are discharged, and a current flows through the MOS transistor 51 and the VCSEL that are connected in series, so that the VCSEL emits light.

When a signal generated by the signal generation circuit 52 in the drive unit 50 is at an "L level", the MOS transistor 51 shifts from an ON state to an OFF state. Accordingly, the VCSEL stops emitting light. Then, the power supply 82 resumes the accumulation of electric charges in the capacitor 70.

As described above, each time when the signal output from the signal generation circuit 52 shifts between the "L level" and the "H level", the MOS transistor 51 is repeatedly turned on and turned off, and emission of light and non-emission of light that is a state in which the VCSEL stops emitting light are repeated. That is, a light pulse is emitted from the VCSEL. Repetition of ON and OFF of the MOS transistor 51 may be referred to as switching. Here, as illustrated in the equivalent circuit of Fig. 6, a current path to the light source 20, which includes the light source 20, the MOS transistor 51, the capacitor 70, and the like, is referred to as a circuit or a circuit for driving the light source 20.

Although charges (a current) may be directly supplied from the power supply 82 to the VCSEL without providing the capacitor 70, the electric charges are accumulated in the capacitor 70, and the accumulated charges are discharged when the MOS transistor 51 is switched from an OFF state to an ON state to rapidly supply a current to the VCSEL, so that a rise time of light emission of the VCSEL is reduced.

The PD 40 is connected in a reverse direction between the power supply line 83 and the ground line 84 via the detection resistor element 41. Therefore, no current flows in a state where light is not radiated. As described above, when the PD 40 receives a part of light reflected by the light diffusing member 30 among the light emitted from the VCSEL, a current corresponding to a received light amount flows through the PD 40. Therefore, the current flowing through the PD 40 is measured as a voltage of the output terminal 42, and a light intensity of the light source 20 is detected. Therefore, the optical device control unit 8 controls the light intensity of the light source 20 to be a predetermined light intensity based on the received light amount of the PD 40. For example, when the light intensity of the light source 20 is lower than the predetermined light intensity, the optical device control unit 8 increases the power supply potential of the power supply 82 to increase an amount of electric charges accumulated in the capacitor 70, thereby increasing a current flowing through the VCSEL. On the other hand, when the light intensity of the light source 20 is higher than the predetermined light intensity, the power supply potential of the power supply 82 is lowered to reduce the amount of electric charges accumulated in the capacitor 70, thereby reducing the current flowing through the VCSEL. In this way, the light intensity of the light source 20 is controlled.

In addition, when the received light amount of the PD 40 is extremely low, the light diffusing member 30 may be detached or damaged, and the light emitted from the light source 20 may be directly irradiated to the outside. In such a case, the light intensity of the light source 20 is suppressed by the optical device control unit 8. For example, emission of light from the light source 20, that is, radiation of light onto an object to be measured, is stopped.

As described above, the PD 40 is provided to detect the light intensity of the light source 20. Therefore, as the PD 40 is disposed farther from the light source 20, a received light amount thereof decreases, and detection sensitivity of the light intensity of the light source 20 decreases. Therefore, the PD 40 may be disposed close to the light source 20. That is, the PD 40 is an example of a circuit element expected to be disposed close to the light source 20. In addition, if the PD 40 is disposed close to the light source 20, area of the light diffusing member 30 can be reduced. That is, the expensive light diffusing member 30 is reduced in size, and the light-emitting device 4 becomes inexpensive.

### (Light-Emitting Device 4)

Next, the light-emitting device 4 will be described in detail.

Fig. 7 is a diagram illustrating the light-emitting device 4 to which the first embodiment of the invention is applied. (a) of Fig. 7 is a plan view, (b) of Fig. 7 is a cross-sectional view taken along a line VIIB-VIIB in (a) of Fig. 7, and (c) of Fig. 7 is a cross-sectional view taken along a line VIIC-VIIC in (a) of Fig. 7. In (a) of Fig. 7, a right direction of a paper surface is defined as the x direction, an upper direction of the paper surface is defined as the y direction. A direction orthogonal to the x direction and the y direction in a counterclockwise manner is defined as the z direction. Therefore, in (b) and (c) of Fig. 7, a right direction of the paper surface is defined as the x direction, and an upper direction of the paper is defined as the z direction. The same applies to similar drawings to be described below.

As illustrated in (b) and (c) of Fig. 7, the base member 100 and the drive unit 50 are provided on the wiring substrate 10 in the light-emitting device 4. The light source 20, the PD 40, and the holding portion 60 are provided on the base member 100. The light diffusing member 30 is provided on the holding portion 60. As illustrated in (a) and (c) of Fig. 7, the light source 20 and the PD 40 are covered by the light diffusing member 30. Therefore, a part of light reflected by a back surface of the light diffusing member 30 among the light emitted from the light source 20 is received by the PD 40. The holding portion 60 may be provided on the wiring substrate 10.

As illustrated in (a) of Fig. 7, in the light-emitting device 4, the light source 20, the PD 40, and the drive unit 50 are linearly arranged in the x direction. In the light-emitting device 4, even in a configuration in which the PD 40 is disposed between the light source 20 and the drive unit 50 and the PD 40 is disposed close to the light source 20, a path of a wiring pattern (a light-source cathode wiring pattern 12 to be described later) connecting the light source 20 and the drive unit 50 is not restricted by the PD 40.

That is, in the light-emitting device 4, the light source 20 and the PD 40 are mounted on the base member 100 provided with a wiring pattern, and the base member 100 is mounted on the wiring substrate 10 provided with a wiring pattern for connecting to the drive unit 50, and thus the path of the wiring pattern connecting the light source 20 and the drive unit 50 is not restricted by the PD 40 thanks to three-dimensional intersection of the wiring patterns.

This will be described in detail below.

The wiring substrate 10 is, for example, a three-layer multilayer substrate. That is, the wiring substrate 10 includes a first conductive layer, a second conductive layer, and a third conductive layer from a side where the base member, the drive unit 50, and the like are mounted. Further, an insulating layer is provided between the first conductive layer and the second conductive layer, and between the second conductive layer and the third conductive layer. For example, the third conductive layer is the power supply line 83, and the second conductive layer is the ground line 84. A light-source anode wiring pattern 11 that constitutes a part of a current path to the light source 20, the light-source cathode wiring pattern 12, a PD anode wiring pattern 13 that constitutes a part of a current path to the PD 40, and a PD cathode wiring pattern 14 are formed by the first conductive layer. Further, wiring patterns to which circuit components such as the capacitor 70, the resistor element 6, and the capacitor 7 are connected are formed by the first conductive layer, and these wiring patterns are not illustrated. In this manner, the wiring substrate 10 is a multilayer substrate, the power supply line 83 is the third conductive layer, and the ground line 84 is the second conductive layer, so that a fluctuation in the power supply potential and the ground potential is easily suppressed. A path through which a current flows, such as the light-source anode wiring pattern 11, the light-source cathode wiring pattern 12, the PD anode wiring pattern 13, and the PD cathode wiring pattern 14, is referred to as a wiring pattern. A wiring pattern formed by the first conductive layer, and the second conductive layer or the third conductive layer are electrically connected to each other via a via. For example, the via is a conductive portion formed by embedding a conductive material in a hole provided in a manner of penetrating the wiring substrate 10 in a thickness direction thereof.

The first conductive layer, the second conductive layer, and the third conductive layer are formed of a metal such as copper (Cu) or silver (Ag) or a conductive material such as a conductive paste containing these metals. The insulating layer is formed of epoxy resin, ceramic, or the like.

The base member 100 is formed of an electrically insulating material. Since the light source 20 is provided on the base member 100, the base member 100 may be formed of a heat dissipation member that has an electrically insulating property and a higher thermal conductivity higher than the wiring substrate 10. Examples of the heat dissipation member that has an electrically insulating property include ceramics such as silicon nitride and aluminum nitride. When the base member 100 is a heat dissipation member, heat generated by the light source 20 is easily transferred to the holding portion 60 and the light diffusion member 30 via the base member 100 and dissipated, and heat dissipation efficiency is improved.

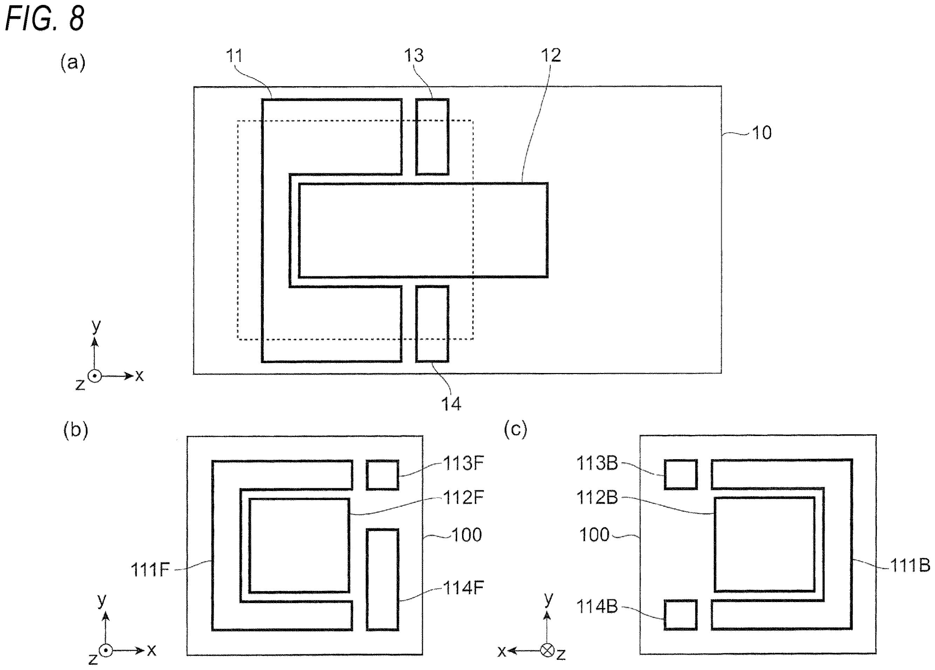

A light-source anode wiring pattern 111F that constitutes a part of a current path to the light source 20, a light-source cathode wiring pattern 112F, a PD anode wiring pattern 113F that constitutes a part of a current path to the PD 40, and a PD cathode wiring pattern 114F are provided on a front surface of the base member 100. A light-source anode wiring pattern 111B that constitutes a part of a current path to the light source 20, a light-source cathode wiring pattern 112B, a PD anode wiring pattern 113B that constitutes a part of a current path to the PD 40, and a PD cathode wiring pattern 114B are provided on a back surface of the base member 100 (see Fig. 8 to be described later). Wiring patterns, which are denoted by the same number and are on the front surface and the back surface of the base member 100, are connected to each other by a via. For example, as illustrated in (b) of Fig. 7, the light-source anode wiring pattern 111F provided on the front surface and the light-source anode wiring pattern 111B provided on the back surface are connected by a via 111V. The via is denoted by adding "V" to a reference number of a wiring pattern. Here, the via is, for example, a conductive portion formed by embedding a conductive material in a hole that is provided in a manner of penetrating the base member 100, and the via electrically connects wiring patterns on the front surface and wiring patterns on the back surface. Inductance of a circuit is reduced by connecting the wiring patterns using plural vias.

The light-source cathode wiring pattern 112F of the base member 100 and the cathode electrode 214 (see Fig. 4) of the light source 20 are connected by a conductive adhesive or the like. The light-source anode wiring pattern 111F of the base member 100 and the anode electrode 218 (see Fig. 4) of the light source 20 are connected to each other by bonding wires 23A, 23B, and 23C on the side surfaces 21A, 21B, and 22A side of the light source 20. Here, the light-source anode wiring pattern 111F is provided on the side surfaces 21A, 21B, and 22A side of the light source 20, and is not provided on the side surface 22B side of the light source 20. In this manner, the bonding wire connecting the anode electrode 218 and the light-source anode wiring pattern 111F is not provided on the side surface 22B side of the light source 20. Therefore, the PD 40, which is an example of a circuit element desired to be disposed close to the light source 20, is disposed close to the light source 20.

In the above description, the anode electrode 218 of the light source 20 and the light-source anode wiring pattern 111F are connected to each other on the three side surface (side surfaces 21A, 21B, and 22A) sides of the light source 20 by the bonding wires (bonding wires 23A, 23B, and 23C). The anode electrode 218 of the light source 20 and the light-source anode wiring pattern 111F may be connected to each other by a bonding wire on at least two side surface sides of the light source 20. As compared with a case where the anode electrode 218 of the light source 20 and the light-source anode wiring pattern 111F are connected by a bonding wire on two side surface sides, the inductance of the circuit is reduced in the case where the anode electrode 218 of the light source 20 and the light-source anode wiring pattern 111F are connected on three side surface sides. The anode electrode 218 of the light source 20 and the light-source anode wiring pattern 111F may be connected to each other by a bonding wire on two side surface (side surfaces 21A and 21B) sides, and another circuit element may be provided on the base member 100 on the third side surface (side surface 22A) side. The other circuit element is, for example, a temperature sensor. By providing the other circuit element, the inductance of the circuit can be reduced.

In the PD 40, a cathode electrode of the PD 40 is bonded to the PD cathode wiring pattern 114F of the base member 100 by a conductive adhesive, and an anode electrode of the PD 40 is connected to the PD anode wiring pattern 113F of the base member 100 by a bonding wire 23D.

The light-source anode wiring pattern 11 and the light-source cathode wiring pattern 12 that are provided on the wiring substrate 10 are respectively connected to the light-source anode wiring pattern 111B and the light-source cathode wiring pattern 112B on the back surface of the base member 100. Similarly, the PD anode wiring pattern 13 and the PD cathode wiring pattern 14 that are provided on the wiring substrate 10 are respectively connected to the PD anode wiring pattern 113B and the PD cathode wiring pattern 114B on the back surface of the base member 100. The wiring patterns of the wiring substrate 10 and the wiring patterns of the base member 100 are connected by a conductive adhesive or the like.

As illustrated in (b) of Fig. 7, in the cross-sectional view taken along the line VIIB-VIIB shifted to the -y direction side from a center in the y direction, the light-source anode wiring pattern 11 of the wiring substrate 10 and the light-source anode wiring pattern 111B on the back surface of the base member 100 are connected to each other. The light-source anode wiring pattern 111B of the base member 100 is connected to the light-source anode wiring pattern 111F on the front surface of the base member 100 via the via 111V. The light-source anode wiring pattern 111F of the base member 100 is connected to the anode electrode 218 (see Fig. 4) of the light source 20 via the bonding wires 23A, 23B, and 23C.

Similarly, the PD cathode wiring pattern 14 of the wiring substrate 10 is connected to the PD cathode wiring pattern 114B provided on the back surface of the base member 100. The PD cathode wiring pattern 114B of the base member 100 is connected to the PD cathode wiring pattern 114F provided on the front surface of the base member 100 via a via 114V. The PD cathode wiring pattern 114F of the base member 100 is connected to the cathode electrode of the PD 40.

That is, in the cross section taken along the line VIIB-VIIB, the light-source anode wiring pattern 11 of the wiring substrate 10, the light-source anode wiring pattern 111B on the back surface of the base member 100, and the light-source anode wiring pattern 111F on the front surface of the base member 100 are provided in a manner of facing one another. Similarly, the PD cathode wiring pattern 14 of the wiring substrate 10, the PD cathode wiring pattern 114B provided on the back surface of the base member 100, and the PD cathode wiring pattern 114F provided on the front surface of the base member 100 are provided in a manner of facing one another.

On the other hand, as illustrated in (c) of Fig. 7, in the cross-sectional view taken along the line VIIC-VIIC in a central portion in the y direction, the light-source cathode wiring pattern 12 of the wiring substrate 10 is provided in a manner of extending from a lower side of the light source 20 to the drive unit 50. The light-source anode wiring pattern 11 of the wiring substrate 10 is connected to the light-source anode wiring pattern 111B provided on the back surface of the base member 100, and the light-source cathode wiring pattern 12 is connected to the light-source cathode wiring pattern 112B provided on the back surface of the base member 100. The light-source anode wiring pattern 111B of the base member 100 is connected to the light-source anode wiring pattern 111F provided on the front surface of the base member 100 via the via 111V, and the light-source cathode wiring pattern 112B is connected to the light-source cathode wiring pattern 112F provided on the front surface of the base member 100 via a via 112V The light-source cathode wiring pattern 112F is connected to the cathode electrode 214 of the light source 20.

However, in the VIIC-VIIC cross section illustrated in (c) of Fig. 7, the PD cathode wiring pattern 114F on the base member 100 is not connected to the light-source cathode wiring pattern 12 provided on the wiring substrate 10.

That is, in the cross section taken along the line VIIC-VIIC, the light-source anode wiring pattern 11 of the wiring substrate 10, the light-source anode wiring pattern 111B on the back surface of the base member 100, and the light-source anode wiring pattern 111F on the front surface of the base member 100 are provided in a manner of facing one another. However, although the light-source cathode wiring pattern 112B on the back surface of the base member 100 and the light-source cathode wiring pattern 112F on the front surface of the base member 100 are provided in a manner of facing each other, the light-source cathode wiring pattern 12 of the wiring substrate 10 is provided in a manner of extending from a portion facing the light-source cathode wiring pattern 112B to the drive unit 50. In addition, a wiring pattern facing the PD cathode wiring pattern 114F on the base member 100 is not provided on the back surface of the base member 100. That is, the PD cathode wiring pattern 114F on the base member 100 and the light-source cathode wiring pattern 12 provided on the wiring substrate 10 intersect three-dimensionally with each other but are not electrically connected to each other. That is, the base member 100 is provided across the light-source cathode wiring pattern 12. In this way, the light-source cathode wiring pattern 12 of the wiring substrate 10 is provided to extend from the light source 20 to the drive unit 50 at the back surface of the base member 100, and the PD 40 is provided in a region on the base member 100, which is a region overlapping the light-source cathode wiring pattern 12 in a plan view. When the base member 100 is not provided across the light-source cathode wiring pattern 12, and the base member 100 is provided at one side in a width direction of the light-source cathode wiring pattern 12, a size of the light-emitting device 4 increases.

As described above, as illustrated in (a) of Fig. 7, in the light-emitting device 4 to which the first embodiment is applied, even in the configuration in which the PD 40 is disposed close to the light source 20 and the PD 40 is disposed between the light source 20 and the drive unit 50, the wiring pattern (here, the light-source cathode wiring pattern 12) connecting the light source 20 and the drive unit 50 is linearly provided. Accordingly, the wiring pattern (here, the light-source cathode wiring pattern 12) connecting the light source 20 and the drive unit 50 is shortened, and an increase in inductance of the circuit is suppressed. That is, a path of a wiring pattern connecting the light source 20 and the drive unit 50 is not restricted by the PD 40.

Next, the wiring patterns provided on the wiring substrate 10 and the base member 100 will be described in detail.

Fig. 8 is a diagram illustrating the wiring patterns provided on the wiring substrate 10 and the base member 100. (a) of Fig. 8 shows a front surface of the wiring substrate 10, (b) of Fig. 8 shows the front surface of the base member 100, and (c) of Fig. 8 shows the back surface of the base member 100. (a) of Fig. 8 shows a wiring pattern formed by the first conductive layer of the wiring substrate 10, and does not show a wiring pattern formed by the second conductive layer that is the ground line 84 and a wiring pattern formed by the third conductive layer that is the power supply line 83. The second conductive layer and the third conductive layer are solid films without a portion where a via used to connect to the wiring pattern formed by the first conductive layer is provided.

On the front surface of the wiring substrate 10 illustrated in (a) of Fig. 8, the light-source anode wiring pattern 11 and the light-source cathode wiring pattern 12 are provided. The light-source cathode wiring pattern 12 has a quadrangular planar shape. The light-source anode wiring pattern 11 is provided adjacent to a short side of the light-source cathode wiring pattern 12 on the -x direction side, and extends along two long sides connected to the short side. Further, on the front surface of the wiring substrate 10, the PD anode wiring pattern 13 and the PD cathode wiring pattern 14 are provided. The PD anode wiring pattern 13 and the PD cathode wiring pattern 14 are provided so as to sandwich the light-source cathode wiring pattern 12 from the ± y direction.

On the front surface of the base member 100 illustrated in (b) of Fig. 8, the light-source anode wiring pattern 111F and the light-source cathode wiring pattern 112F are provided. The light-source cathode wiring pattern 112F has a quadrangular planar shape corresponding to the planar shape of the light source 20 illustrated in Fig. 3. The light-source anode wiring pattern 111F is provided adjacent to three sides of the light-source cathode wiring pattern 112F. Further, on the front surface of the base member 100, the PD anode wiring pattern 113F and the PD cathode wiring pattern 114F are provided.

On the back surface of the base member 100 illustrated in (c) of Fig. 8, the light-source anode wiring pattern 111B connected to the light-source anode wiring pattern 111F via the via 111V, the light-source cathode wiring pattern 112B connected to the light-source cathode wiring pattern 112F via the via 112V, the PD anode wiring pattern 113B connected to the PD anode wiring pattern 113F via a via 113V, and the PD cathode wiring pattern 114B connected to the PD cathode wiring pattern 114F via the via 114V are provided. In the base member 100, the wiring patterns on the front surface shown in (b) of Fig. 8 and the wiring patterns on the back surface shown in (c) of Fig. 8 are mirror-inverted except for the PD anode wiring pattern 113F and the PD anode wiring pattern 113B. That is, the wiring patterns on the front surface and the wiring patterns on the back surface, of the base member 100, are provided in a manner of overlapping one another in a plan view. The light-source cathode wiring pattern 12 is a wiring pattern on the wiring substrate 10 that is connected to the light source 20 and extends from the back surface side of the base member 100 to the drive unit 50.

On the other hand, with respect to the PD anode wiring pattern 113F and the PD anode wiring pattern 113B, the PD anode wiring pattern 113F on the front surface has a longer length in the y direction than the PD anode wiring pattern 113B on the back surface, and extends to a central portion in the y direction of the base member 100.

When the base member 100 is disposed at a portion indicated by a surrounding broken line of the wiring substrate 10 in (a) of Fig. 8, the light-source anode wiring pattern 11 of the wiring substrate 10 and the light-source anode wiring pattern 111B of the base member 100 are connected, and the light-source cathode wiring pattern 12 of the wiring substrate 10 and the light-source cathode wiring pattern 112B of the base member 100 are connected. Similarly, the PD anode wiring pattern 13 of the wiring substrate 10 is connected to the PD anode wiring pattern 113B of the base member 100, and the PD cathode wiring pattern 14 of the wiring substrate 10 is connected to the PD cathode wiring pattern 114B of the base member 100.

At this time, if the PD cathode wiring pattern 114B on the back surface has the same shape as the PD cathode wiring pattern 114F on the front surface in the base member 100, the PD cathode wiring pattern 114B short-circuits the light-source cathode wiring pattern 12 and the PD cathode wiring pattern 14 of the wiring substrate 10. Therefore, in the base member 100, a length in the +y direction of the PD cathode wiring pattern 114B on the back surface is made shorter than that of the PD cathode wiring pattern 114F on the front surface, and the PD cathode wiring pattern 114B does not short-circuit the light-source cathode wiring pattern 12 and the PD cathode wiring pattern 14 of the wiring substrate 10. That is, in order to dispose the PD 40 between the light source 20 and the drive unit 50, the PD cathode wiring pattern 114F connected to the cathode electrode of the PD 40 is provided on the base member 100, so that the PD 40 three-dimensionally intersects with the light-source cathode wiring pattern 12 provided on the wiring substrate 10 without being short-circuited.

Before the base member 100 is disposed on the wiring substrate 10, the light source 20 and the PD 40 are mounted on the base member 100. That is, the cathode electrode 214 (see Fig. 4) of the light source 20 is bonded onto the light-source cathode wiring pattern 112F of the base member 100 by a conductive adhesive or the like. The anode electrode 218 (see Fig. 4) of the light source 20 and the light-source anode wiring pattern 111F are connected by the bonding wires 23A, 23B, and 23C.

Further, the cathode electrode of the PD 40 is bonded onto the PD cathode wiring pattern 114F of the base member 100 by a conductive adhesive, and the anode electrode of the PD 40 is connected to the PD anode wiring pattern 113F of the base member 100 by the bonding wire 23D.

As described above, in the light-emitting device 4 of the first embodiment, by using the base member 100, even in the configuration in which the PD 40 is disposed between the light source 20 and the drive unit 50, the path of the wiring pattern connecting the light source 20 and the drive unit 50 is not restricted by the PD 40. Accordingly, an increase in inductance of the circuit is suppressed.

As described above, the anode electrode and the cathode electrode of the PD 40 are separated on two sides to sandwich the light-source cathode wiring pattern 12 provided on the wiring substrate 10, and are connected to the PD anode wiring pattern 13 and the PD cathode wiring pattern 14. That is, the PD 40 is connected to the wiring substrate 10 on outer sides such that the light-source cathode wiring pattern 12 is sandwiched.

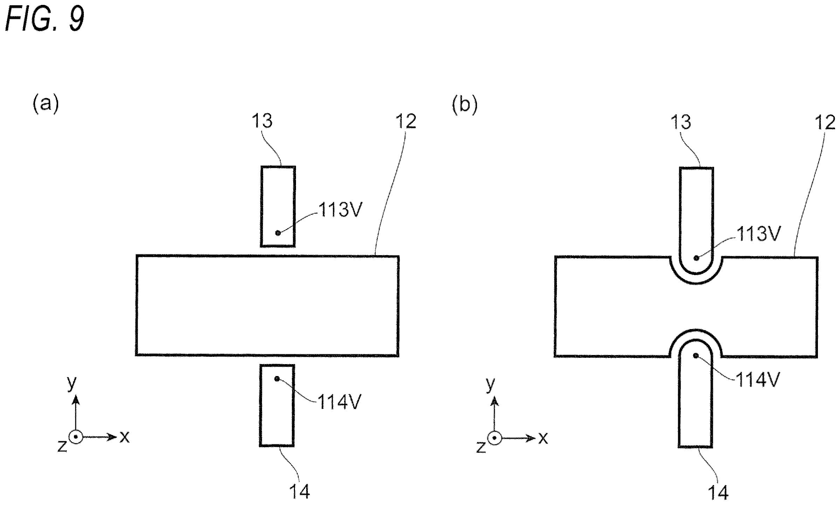

Fig. 9 is a diagram illustrating a relationship in which the PD 40 is provided at an outer side of the light-source cathode wiring pattern 12 in the wiring substrate 10. (a) of Fig. 9 is a first example and (b) of Fig. 9 is a second example.

The first example illustrated in (a) of Fig. 9 is the same as that illustrated in Fig. 8. In the first example, the light-source cathode wiring pattern 12 linearly connects the light source 20 and the drive unit 50. The light-source cathode wiring pattern 12 is formed to have a quadrangular planar shape. That is, even when the PD anode wiring pattern 13 and the PD cathode wiring pattern 14 for connecting the PD 40 are provided, the light-source cathode wiring pattern 12 is provided with the same line width without being affected by the PD anode wiring pattern 13 and the PD cathode wiring pattern 14. Therefore, with the light-source cathode wiring pattern 12, the light source 20 and the drive unit 50 are linearly provided at a shortest distance, an increase in inductance of the circuit is suppressed. Resistance of the light-source cathode wiring pattern 12 is smaller than that of the second example to be described below.

In the second example illustrated in (b) of Fig. 9, in order to provide the PD 40, the light-source cathode wiring pattern 12 is provided so as to be narrowed at portions where the PD anode wiring pattern 13 and the PD cathode wiring pattern 14 are provided. Therefore, the resistance of the light-source cathode wiring pattern 12 is larger than that of the first example. However, also in the second example, the light source 20 and the drive unit 50 are linearly provided at a shortest distance. That is, the light-source cathode wiring pattern 12 is less likely to be affected by the provision of the PD 40. The light-source cathode wiring pattern 12 may be configured as described above.

As described above, since the PD 40 is connected to the wiring substrate 10 on the outer sides such that the light-source cathode wiring pattern 12 is sandwiched from both sides, a path of the light-source cathode wiring pattern 12 is not affected as compared with a case where the PD 40 is provided on an inner side of a light-source cathode wiring pattern 12' shown in a light-emitting device 4-2 of a second comparative example described later. Therefore, an increase in inductance of the circuit is suppressed. The PD anode wiring pattern 13 and the PD cathode wiring pattern 14 are an example of a connection portion of the PD 40, which is an example of a circuit element, with the wiring substrate 10, and the anode electrode of the PD 40 is an example of a first electrode and the cathode electrode thereof is an example of a second electrode.

In the light-emitting device 4 of the first embodiment, the base member 100 is used. Hereinafter, a light-emitting device in which the base member 100 is not used will be described as a comparative example.

### (Light-Emitting Device of Comparative Example)

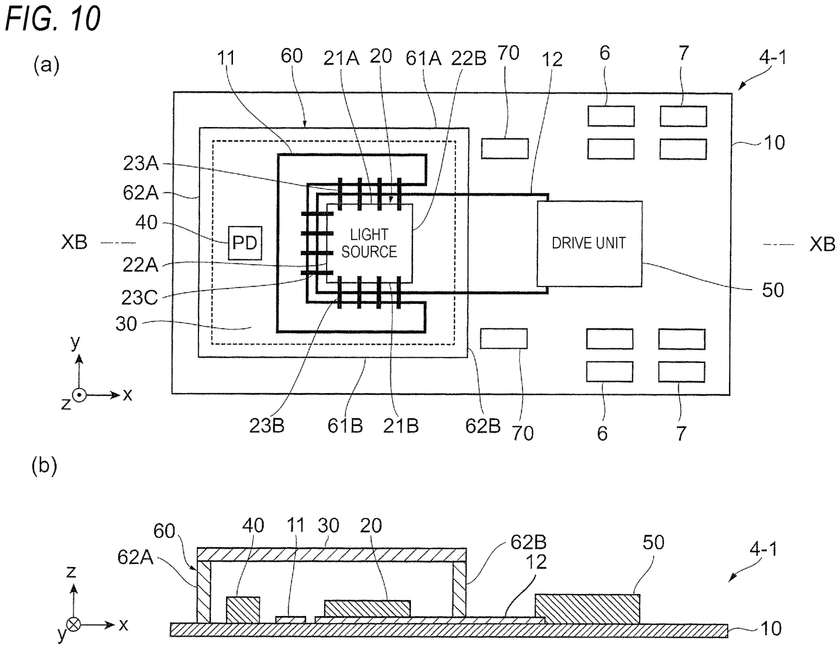

Fig. 10 is a diagram illustrating a light-emitting device 4-1 of a first comparative example, not part of the claimed invention. (a) of Fig. 10 is a plan view, and (b) of Fig. 10 is a cross-sectional view taken along a line XB-XB in (a) of Fig. 10. The light-emitting device 4-1 does not use the base member 100 used in the light-emitting device 4. That is, in the light-emitting device 4-1, the light source 20, the PD 40, the drive unit 50, and other circuit components are provided on the wiring substrate 10.

In the light-emitting device 4-1 of the first comparative example, as illustrated in (a) of Fig. 10, the PD 40, the light source 20, and the drive unit 50 are arranged along the x direction of the wiring substrate 10. Therefore, on the side surface 22B side of the light source 20, the light source 20 and the drive unit 50 are connected by the light-source cathode wiring pattern 12. Therefore, as illustrated in (a) and (b) of Fig. 10, the light-source cathode wiring pattern 12 is set between the light source 20 and the drive unit 50 without being affected by the PD 40.

On the other hand, the PD 40 has to be disposed on a side surface side other than the side surface 22B side of the light source 20 on which the light-source cathode wiring pattern 12 is provided, that is, on the side surfaces 21A, 21B, 22A side. However, the light-source anode wiring pattern 11 is provided on the side surfaces 21A, 21B, and 22A side. The light-source anode wiring pattern 11 and the anode electrode 218 of the light source 20 are connected by the bonding wires 23A, 23B, and 23C. For this reason, the PD 40 has to be disposed at an outer side of the light-source anode wiring pattern 11, which is a -x side, and the light source 20 and the PD 40 are not disposed close to each other.

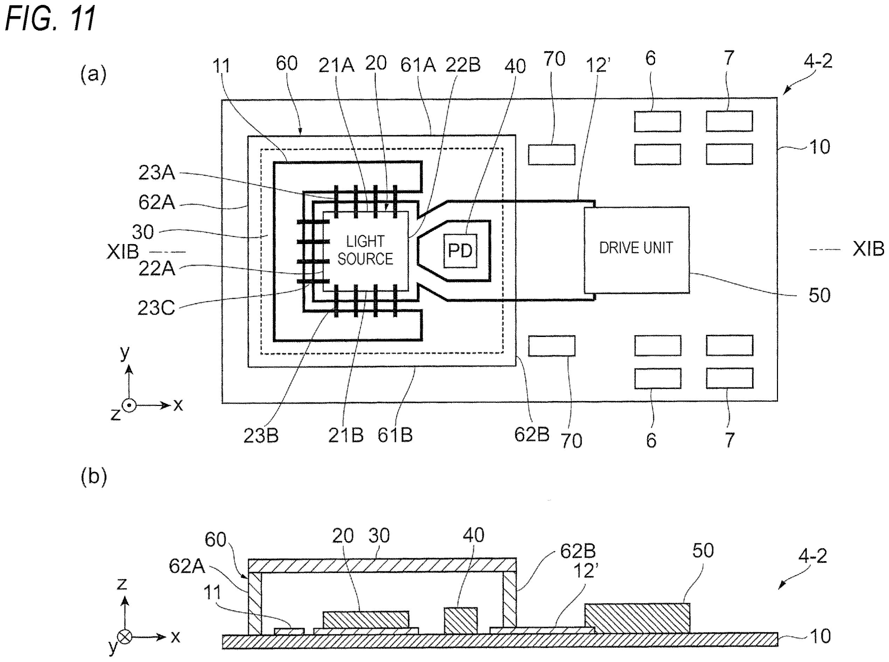

Fig. 11 is a diagram illustrating the light-emitting device 4-2 of the second comparative example, not part of the claimed invention. (a) of Fig. 11 is a plan view, and (b) of Fig. 11 is a cross-sectional view taken along a line XIB-XIB in (a) of Fig. 11. The light-emitting device 4-2 does not use the base member 100 used in the light-emitting device 4. That is, in the light-emitting device 4-2, the light source 20, the PD 40, the drive unit 50, and other circuit components are provided on the wiring substrate 10.

In the light-emitting device 4-2 of the second comparative example, as illustrated in (b) of Fig. 11, the light source 20, the PD 40, and the drive unit 50 are linearly arranged in the x direction of the wiring substrate 10. That is, the PD 40 is disposed between the light source 20 and the drive unit 50. Similarly to the light-emitting device 4-1, the light-source anode wiring pattern 11 is provided on the side surfaces 21A, 21B, and 22A side of the light source 20, and the light-source anode wiring pattern 11 and the light-source anode electrode 218 of the light source 20 are connected by the bonding wires 23A, 23B, and 23C. The PD 40 is provided on the side surface 22B side where the light-source anode wiring pattern 11 is not provided. Therefore, the PD 40 desired to be provided close to the light source 20 is disposed close to the light source 20.

On the other hand, the light-source cathode wiring pattern 12' is provided to be branched so as to include the PD 40 on an inner side. That is, the light-source cathode wiring pattern 12' has to be provided so as to bypass the PD 40. As described above, in the light-emitting device 4-2, the light-source cathode wiring pattern 12' connecting the light source 20 and the drive unit 50 is affected by arrangement of the PD 40, and inductance of the circuit increases.

As described above, by providing the base member 100 as in the light-emitting device 4 to which the first embodiment is applied, the path of the wiring pattern (here, the light-source cathode wiring pattern 12) connecting the light source 20 and the drive unit 50 is not restricted by the PD 40 even in a configuration in which a circuit element (here, the PD 40 as an example) desired to be provided close to the light source 20 is disposed between the light source 20 and the drive unit 50.

### [Second Embodiment]

In the light-emitting device 4 to which the first embodiment of the invention is applied, the PD 40 desired to be disposed close to the light source 20 is provided on the base member 100. In a light-emitting device 4A to which the second embodiment of the invention is applied, as to be described later, the light source 20 is not provided on a base member 150.

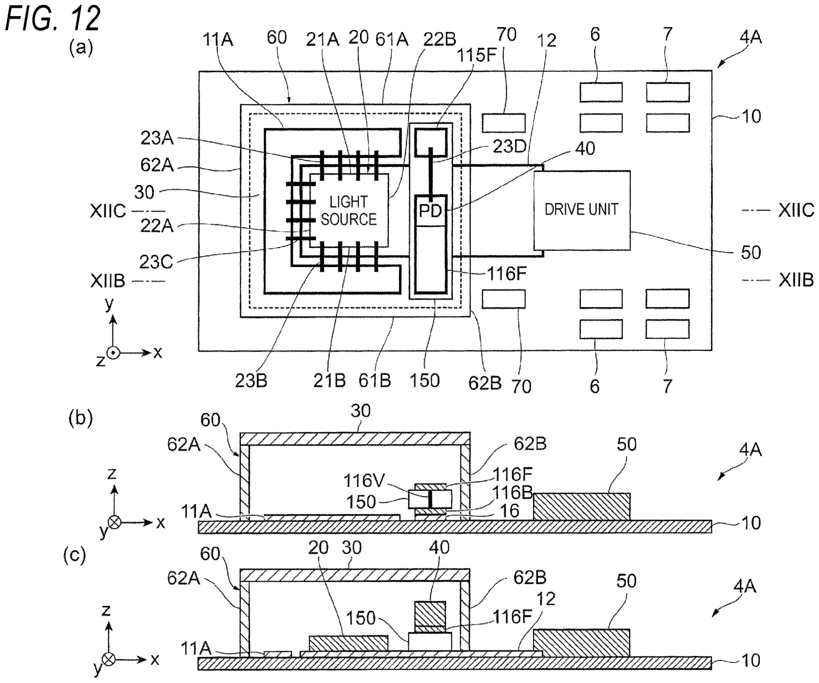

Fig. 12 is a diagram illustrating the light-emitting device 4A to which the second embodiment of the invention is applied. (a) of Fig. 12 is a plan view, (b) of Fig. 12 is a cross-sectional view taken along a line XIIB-XIIB in (a) of Fig. 12, and (c) of Fig. 12 is a cross-sectional view taken along a line XIIC-XIIC in (a) of Fig. 12. The same components as those of the light-emitting device 4 are denoted by the same reference signs, and a description thereof will be omitted.

As illustrated in (b) and (c) of Fig. 12, in the light-emitting device 4A, the light source 20, the base member 150, the drive unit 50, and the holding portion 60 are provided on the wiring substrate 10. The PD 40 is provided on the base member 150. In the light-emitting device 4A, the holding portion 60 is provided on the wiring substrate 10, and the light diffusing member 30 is held by the holding portion 60. Here, the base member 150 may be formed of an electrically insulating material. The wiring substrate 10 on which the light source 20 is provided may be a heat dissipation substrate having a thermal conductivity higher than the base member 150.

As illustrated in (a) of Fig. 12, in the light-emitting device 4A, the light source 20, the PD 40, and the drive unit 50 are linearly arranged in the x direction. In the light-emitting device 4A, even in a configuration in which the PD 40 is disposed between the light source 20 and the drive unit 50 and the PD 40 is disposed close to the light source 20, a path of a wiring pattern (a light-source cathode wiring pattern 12 to be described later) connecting the light source 20 and the drive unit 50 is not restricted by the PD 40.

A light-source anode wiring pattern 11A that constitutes a part of a current path to the light source 20, the light-source cathode wiring pattern 12, a PD anode wiring pattern 15 that constitutes a part of a current path to the PD 40, and a PD cathode wiring pattern 16 are formed by a first conductive layer of the wiring substrate 10. In (a) of Fig. 12, the PD anode wiring pattern 15 and the PD cathode wiring pattern 16 are not illustrated due to being on a back surface side of the base member 150. The light-source anode wiring pattern 11A is narrower than the light-source anode wiring pattern 11 shown in (a) of Fig. 8.

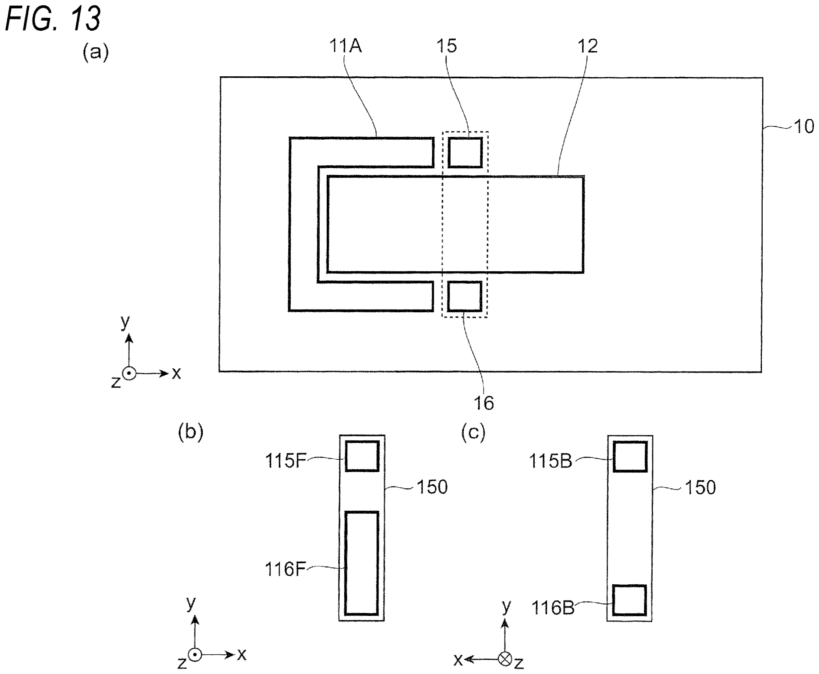

On a front surface of the base member 150, a PD anode wiring pattern 115F and a PD cathode wiring pattern 116F that constitute a part of a current path to the PD 40 are provided. On a back surface of the base member 150, a PD anode wiring pattern 115B and a PD cathode wiring pattern 116B that constitute a part of a current path to the PD 40 are also provided (see Fig. 13 to be described later). Wiring patterns, which are denoted by the same number and are on the front surface and the back surface of the base member 150, are connected to each other by a via.

The light-source cathode wiring pattern 12 of the wiring substrate 10 and the cathode electrode 214 (see Fig. 4) of the light source 20 are bonded to each other by a conductive adhesive or the like. The light-source anode wiring pattern 11A of the wiring substrate 10 and the anode electrode 218 (see Fig. 4) of the light source 20 are connected to each other by the bonding wires 23A, 23B, and 23C on the side surfaces 21A, 21B, and 22A side of the light source 20. Here, the light-source anode wiring pattern 11A is provided on the side surfaces 21A, 21B, and 22A side of the light source 20, and is not provided on the side surface 22B side of the light source 20. In this manner, the bonding wire connecting the anode electrode 218 and the light-source anode wiring pattern 11A is not provided on the side surface 22B side of the light source 20. Therefore, the PD 40, which is an example of a circuit element desired to be disposed close to the light source 20, is disposed close to the light source 20.

In the PD 40, a cathode electrode of the PD 40 is bonded onto the PD cathode wiring pattern 116F of the base member 100 by a conductive adhesive, and an anode electrode of the PD 40 is connected to the PD anode wiring pattern 115F of the base member 100 by the bonding wire 23D.

The PD anode wiring pattern 15 and the PD cathode wiring pattern 16 that are provided on the wiring substrate 10 are connected to the PD anode wiring pattern 115B and the PD cathode wiring pattern 116B on the back surface of the base member 100, respectively.

As illustrated in (b) of Fig. 12, in the cross-sectional view taken along the line XIIB-XIIB shifted from a center in the y direction to the -y direction side, the PD cathode wiring pattern 16 of the wiring substrate 10 and the PD cathode wiring pattern 116B on the back surface of the base member 150 are connected to each other. The PD cathode wiring pattern 116B of the base member 150 is connected to the PD cathode wiring pattern 116F on the front surface of the base member 150 via a via 116V. The PD cathode wiring pattern 116F of the base member 150 is connected to the cathode electrode of the PD 40.

That is, in the cross section taken along the line XIIB-XIIB, the PD cathode wiring pattern 16 of the wiring substrate 10, the PD cathode wiring pattern 116B on the back surface of the base member 150, and the PD cathode wiring pattern 116F on the front surface of the base member 150 are provided in a manner of facing one another.

On the other hand, as illustrated in (c) of Fig. 12, in the cross-sectional view taken along the line XIIC-XIIC of a central portion in the y direction, the PD cathode wiring pattern 116F on the base member 150 is not connected to the light-source cathode wiring pattern 12 provided on the wiring substrate 10.

That is, in the cross section taken along the line XIIC-XIIC, the light-source cathode wiring pattern 12 of the wiring substrate 10 is provided in a manner of extending from the light source 20 to the drive unit 50. On the wiring substrate 10, a wiring pattern facing the PD cathode wiring pattern 116F on the base member 150 is not provided. In this way, the PD cathode wiring pattern 116F on the base member 150 and the light-source cathode wiring pattern 12 provided on the wiring substrate 10 intersect with each other three-dimensionally but are not electrically connected to each other.

Next, the wiring patterns provided on the wiring substrate 10 and the base member 150 will be described.

Fig. 13 is a diagram illustrating the wiring patterns provided on the wiring substrate 10 and the base member 150. (a) of Fig. 13 shows a front surface of the wiring substrate 10, (b) of Fig. 13 shows the front surface of the base member 100, and (c) of Fig. 13 shows the back surface of the base member 100. (a) of Fig. 13 illustrates a wiring pattern formed by the first conductive layer of the wiring substrate 10.

On the front surface of the wiring substrate 10 illustrated in (a) of Fig. 13, the light-source anode wiring pattern 11A and the light-source cathode wiring pattern 12 are provided. The light-source cathode wiring pattern 12 is the same as the light-source cathode wiring pattern 12 illustrated in (a) of Fig. 8, and thus is denoted by the same reference sign. On the front surface of the wiring substrate 10, the PD anode wiring pattern 15 and the PD cathode wiring pattern 16 are provided. The PD anode wiring pattern 15 and the PD cathode wiring pattern 16 have a shorter length in the y direction than the PD anode wiring pattern 13 and the PD cathode wiring pattern 14 that are illustrated in (a) of Fig. 8.

Similar to the PD anode wiring patterns 113F and 113B and the PD cathode wiring patterns 114F and 114B of the base member 100 illustrated in (b) and (c) of Fig. 8, the base member 150 illustrated in (b) and (c) of Fig. 13 is provided with the PD anode wiring pattern 115F and the PD cathode wiring pattern 116F on the front surface thereof and the PD anode wiring pattern 115B and the PD cathode wiring pattern 116B on the back surface thereof. The PD anode wiring pattern 115F on the front surface and the PD anode wiring pattern 115B on the back surface have the same planar shape, and are mirror-inverted on the front and back surfaces of the base member 150. On the other hand, the PD cathode wiring pattern 116F on the front surface has a longer length in the y direction than the PD cathode wiring pattern 116B on the back surface, and extends to a central portion in the y direction of the base member 150. The PD anode wiring pattern 115F on the front surface and the PD anode wiring pattern 115B on the back surface as well as the PD cathode wiring pattern 116F on the front surface and the PD cathode wiring pattern 116B on the back surface are connected by vias provided in a manner of penetrating the base member 150.

When the base member 150 is disposed at a portion indicated by a surrounding broken line of the wiring substrate 10 in (a) of Fig. 13, the PD anode wiring pattern 15 of the wiring substrate 10 and the PD anode wiring pattern 115B of the base member 150 are connected, and the PD cathode wiring pattern 16 of the wiring substrate 10 and the PD cathode wiring pattern 116B of the base member 150 are connected.

At this time, in the base member 150, the PD cathode wiring pattern 116B on the back surface has a shape different from the PD cathode wiring pattern 116F on the front surface, and the light-source cathode wiring pattern 12 of the wiring substrate 10 and the PD cathode wiring pattern 16 are not short-circuited. That is, in order to dispose the PD 40 at a central portion of the wiring substrate 10 in the y direction, the PD cathode wiring pattern 116F connected to the cathode electrode of the PD 40 is provided on the base member 150, so that the PD 40 three-dimensionally intersects with the light-source cathode wiring pattern 12 provided on the wiring substrate 10 without being short-circuited. That is, the base member 150 is provided across the light-source cathode wiring pattern 12. In this way, the light-source cathode wiring pattern 12 of the wiring substrate 10 is provided to extend from the light source 20 to the drive unit 50 at the back surface of the base member 150, and the PD 40 is provided in a region on the base member 100, which is a region overlapping the light-source cathode wiring pattern 12 in a plan view. The light-source cathode wiring pattern 12 is a wiring pattern on the wiring substrate 10 that is connected to the light source 20 and extends from the back surface side of the base member 150 to the drive unit 50.

Before disposing the base member 150 on the wiring substrate 10, the PD 40 is mounted on the base member 150. On the other hand, on the wiring substrate 10, the cathode electrode 214 of the light source 20 is bonded to the light-source cathode wiring pattern 12 by a conductive adhesive. The base member 150 on which the PD 40 is mounted is mounted on the wiring substrate 10. Next, the anode electrode 218 of the light source 20 is connected to the light-source anode wiring pattern 11 by the bonding wires 23A, 23B, and 23C, and the anode electrode of the PD 40 is connected to the PD anode wiring pattern 115F on the base member 150 by the bonding wire 23D.

As described above, by providing the base member 150 in the light-emitting device 4A of the second embodiment, the path of the wiring pattern (here, the light-source cathode wiring pattern 12) connecting the light source 20 and the drive unit 50 is not restricted by the PD 40 even in a configuration in which a circuit element (here, the PD 40 as an example) desired to be provided close to the light source 20 is disposed between the light source 20 and the drive unit 50. Accordingly, an increase in inductance of the circuit is suppressed.

In the first embodiment and the second embodiment described above, a light receiving element (PD40) for monitoring a light amount has been described as an example of a circuit element, and alternatively another circuit component such as a capacitor (capacitor 70) that supplies a current to the light source 20 may be described as a circuit element.

Although the light diffusing member 30 is used in the first embodiment and the second embodiment, the present invention may be applied to a configuration that includes, instead of the light diffusing member 30, a member that transmits light, for example, a transparent base member such as a protective cover, and an optical member such as a condensing lens or a microlens array.

### REFERENCE SIGNS LIST

1 · · · information processing device; 2 · · · user interface (UI) unit; 3 · · · optical device; 4, 4-1, 4-2, 4A · · · light-emitting device; 5 · · · 3D sensor; 6 · · · resistor element; 7, 70 · · · capacitor; 8 · · · optical device control unit; 9 · · · system control unit; 10 · · · wiring substrate; 11, 11A, 111F, 111B · · · light-source anode wiring pattern; 12, 12', 112F, 112B · · · light-source cathode wiring pattern; 13, 15, 113F, 113B, 115F, 115B · · · PD anode wiring pattern; 14, 16, 114F, 114B, 116F, 116B · · · PD cathode wiring pattern; 20 · · · light source; 21A, 21B, 22A, 22B · · · side surface; 23A, 23B, 23C, 23D · · · bonding wire; 30 · · · light diffusing member; 40 · · · PD (light receiving element for monitoring light amount); 50 · · · drive unit; 51 · · · MOS transistor; 52 · · · signal generation circuit; 60 · · · holding portion; 61A, 61B, 62A, 62B · · · wall; 81 · · · shape specifying unit; 82 · · · power supply; 83 · · · power supply line; 84 · · · ground line; 91 · · · authentication processing unit; 100, 150 · · · base member; 200 · · · semiconductor substrate; 202 · · · lower DBR; 206 · · · active region; 208 · · · upper DBR; 210 · · · current confinement layer; 210A · · · oxidized region; 210B · · · conductive region; 214 · · · cathode electrode; 218 . . . anode electrode; M · · · mesa; VCSEL · · · vertical cavity surface emitting laser element

## Claims

1. A light-emitting device (4) comprising:
a wiring substrate (10);
a base member (100) that is mounted on the wiring substrate (10);
a light source (20) that is mounted on a front surface of the base member (150);
a drive unit (50) that is mounted on the wiring substrate and drives the light source (20);
a wiring pattern (11) that is on the wiring substrate (10), is connected to the light source (20) and extends from a back surface side of the base member (100) toward the drive unit (50); and
a circuit element (40) that is provided in a region on the front surface of the base member (100) between the light source (20) and the drive unit (50), the region overlapping the wiring pattern (11) in a plan view, so that a path of the wiring pattern (11) connecting the light source (20) and the drive unit (50) is not restricted by the circuit element (40).

2. The light-emitting device according to claim 1,
wherein the circuit element is electrically connected to the wiring substrate, and the wiring pattern is wired without avoiding a connection portion between the circuit element and the wiring substrate.

3. The light-emitting device (4) according to claim 1 or 2,
wherein the circuit element (40) comprises a first electrode and a second electrode, wherein the first electrode and the second electrode are separated on two sides of the circuit element (40) to sandwich a light-source cathode wiring pattern (12) provided on the wiring substrate (10), and are connected to a circuit element anode wiring pattern (13) and a circuit cathode wiring pattern (14).

4. The light-emitting device (4) according to any one of claims 1 to 3,
wherein the light source (20) is a light-emitting element array that includes a first side surface (21 A) and a second side surface (21B) facing each other, and a third side surface (22A) and a fourth side surface (22B) facing each other and connecting the first side surface (21A) and the second side surface (21B), and
wherein a wiring (218) extending from an upper-surface electrode of the light-emitting element array toward an outer side of the light-emitting element array is provided at least at a side of the first side surface and the second side surface, the circuit element is provided on the base member (100) at a side of the fourth side surface (22B), and the wiring pattern (11) extends from the side of the fourth side surface (22B) toward the drive unit (50).

5. The light-emitting device (4) according to claim 4,
wherein the wiring (218) extending from an upper-surface electrode of the light-emitting element array toward an outer side of the light-emitting element array is provided at a side of the third side (22A) surface.

6. The light-emitting device (4) according to claim 4,
wherein another circuit element is provided on the base member (100) at a side of the third side surface (22A).

7. The light-emitting device (4) according to claim 6,
wherein at least one of the circuit element (40) and the other circuit element is a light receiving element.

8. The light-emitting device (4) according to any one of claims 1 to 7,
wherein the base member (100) is a member having a higher thermal conductivity than the wiring substrate (10).

9. The light-emitting device (4) according to claim 8,
wherein the base member (100) on the wiring substrate (10) is made from ceramic.

10. The light-emitting device (4) according to any one of claims 4 to 7,
wherein a light diffusing member (30) that diffuses, toward an outside, light emitted from the light source (20) is provided on an emission path of the light-emitting element array in the light source (20).

11. The light-emitting device (4) according to any one of claims 4 to 7,
wherein the light-emitting element array comprises a plurality of light-emitting elements connected in parallel to one another.

12. A light-emitting device (4) comprising:
a wiring substrate (10);
a light source (20) and a drive unit (50) driving the light source that are mounted on the wiring substrate (10);
a wiring pattern (11) that is on the wiring substrate (10) and connects the light source (20) and the drive unit (50);
a base member (100) that is provided across the wiring pattern (11) between the light source (20) and the drive unit (50); and
a circuit element (40) that is provided in a region on the front surface of the base member (100), the region overlapping the wiring pattern (11) in a plan view, so that a path of the wiring pattern (11) connecting the light source (20) and the drive unit (50) is not restricted by the circuit element (40).

13. An optical device (3) comprising:
the light-emitting device (4) according to any one of claims 1 to 12; and
a light receiving unit (40) that receives reflected light emitted from the light source included in the light-emitting device (4) and reflected by an object to be measured,
wherein the light receiving unit (40) outputs a signal corresponding to a time from when light is emitted from the light source to when the light is received by the light receiving unit.

14. An information processing device (1) comprising:
the optical device (3) according to claim 13; and
a shape specifying unit (81) that specifies a three-dimensional shape of the object to be measured based on reflected light that is emitted from the light source (20) included in the optical device (3), reflected by the object to be measured, and received by the light receiving unit (40) included in the optical device (3).

15. The information processing device (1) according to claim 14, further comprising:
an authentication processing unit (91) that performs authentication processing related to use of the information processing device (1) based on a specified result of the shape specifying unit (81).

## Patentansprüche

1. Lichtemittierende Vorrichtung (4), umfassend:
ein Verdrahtungssubstrat (10);
ein Basisteil (100), das auf dem Verdrahtungssubstrat (10) montiert ist;
eine Lichtquelle (20), die auf einer Vorderfläche des Basisteils (150) montiert ist;
eine Antriebseinheit (50), die auf dem Verdrahtungssubstrat montiert ist und die Lichtquelle (20) antreibt;
ein Verdrahtungsmuster (11), das sich auf dem Verdrahtungssubstrat (10) befindet, mit der Lichtquelle (20) verbunden ist und sich von einer Rückseite des Basisteils (100) zu der Antriebseinheit (50) erstreckt; und
ein Schaltungselement (40), das in einem Bereich auf der Vorderfläche des Basisteils (100) zwischen der Lichtquelle (20) und der Antriebseinheit (50) bereitgestellt ist, wobei der Bereich das Verdrahtungsmuster (11) in einer Draufsicht überlappt, sodass ein Weg des Verdrahtungsmusters (11), der die Lichtquelle (20) und die Antriebseinheit (50) verbindet, nicht durch das Schaltungselement (40) eingeschränkt ist.

2. Lichtemittierende Vorrichtung nach Anspruch 1,
wobei das Schaltungselement elektrisch mit dem Verdrahtungssubstrat verbunden ist und das Verdrahtungsmuster verdrahtet ist, ohne einen Verbindungsabschnitt zwischen dem Schaltungselement und dem Verdrahtungssubstrat zu vermeiden.

3. Lichtemittierende Vorrichtung (4) nach Anspruch 1 oder 2,
wobei das Schaltungselement (40) eine erste Elektrode und eine zweite Elektrode umfasst, wobei die erste Elektrode und die zweite Elektrode auf zwei Seiten des Schaltungselements (40) getrennt sind, um ein auf dem Verdrahtungssubstrat (10) bereitgestelltes Lichtquellen-Kathoden-Verdrahtungsmuster (12) sandwichartig zu verdrahten, und mit einem Schaltungselement-Anoden-Verdrahtungsmuster (13) und einem Schaltungskathoden-Verdrahtungsmuster (14) verbunden sind.

4. Lichtemittierende Vorrichtung (4) nach einem der Ansprüche 1 bis 3,
wobei die Lichtquelle (20) eine Anordnung lichtemittierender Elemente ist, die eine erste Seitenfläche (21 A) und eine zweite Seitenfläche (21B), die einander zugewandt sind, und eine dritte Seitenfläche (22A) und eine vierte Seitenfläche (22B) beinhaltet, die einander zugewandt sind und die erste Seitenfläche (21A) und die zweite Seitenfläche (21B) verbinden, und
wobei eine Verdrahtung (218), die sich von einer oberseitigen Elektrode der Anordnung lichtemittierender Elemente zu einer Außenseite der Anordnung lichtemittierender Elemente erstreckt, mindestens an einer Seite der ersten Seitenfläche und der zweiten Seitenfläche bereitgestellt ist, das Schaltungselement an dem Basisteil (100) an einer Seite der vierten Seitenfläche (22B) bereitgestellt ist und sich das Verdrahtungsmuster (11) von der Seite der vierten Seitenfläche (22B) zu der Antriebseinheit (50) erstreckt.

5. Lichtemittierende Vorrichtung (4) nach Anspruch 4,
wobei die Verdrahtung (218), die sich von einer oberseitigen Elektrode der Anordnung lichtemittierender Elemente in Richtung einer Außenseite der Anordnung lichtemittierender Elemente erstreckt, an einer Seite der dritten Seitenfläche (22A) bereitgestellt ist.

6. Lichtemittierende Vorrichtung (4) nach Anspruch 4,
wobei ein weiteres Schaltungselement an dem Basisteil (100) an einer Seite der dritten Seitenfläche (22A) bereitgestellt ist.

7. Lichtemittierende Vorrichtung (4) nach Anspruch 6,
wobei mindestens eines von dem Schaltungselement (40) und dem anderen Schaltungselement ein Lichtempfangselement ist.

8. Lichtemittierende Vorrichtung (4) nach einem der Ansprüche 1 bis 7,
wobei das Basisteil (100) ein Teil mit einer höheren Wärmeleitfähigkeit als das Verdrahtungssubstrat (10) ist.

9. Lichtemittierende Vorrichtung (4) nach Anspruch 8,
wobei das Basisteil (100) auf dem Verdrahtungssubstrat (10) aus Keramik hergestellt ist.

10. Lichtemittierende Vorrichtung (4) nach einem der Ansprüche 4 bis 7,
wobei ein lichtstreuendes Element (30), welches das von der Lichtquelle (20) emittierte Licht nach außen streut, in einem Emissionspfad der Anordnung lichtemittierender Elemente in der Lichtquelle (20) bereitgestellt ist.

11. Lichtemittierende Vorrichtung (4) nach einem der Ansprüche 4 bis 7,
wobei die Anordnung lichtemittierender Elemente eine Vielzahl von parallel zueinander geschalteten lichtemittierenden Elementen beinhaltet.

12. Lichtemittierende Vorrichtung (4), umfassend:
ein Verdrahtungssubstrat (10);
eine Lichtquelle (20) und eine Antriebseinheit (50), welche die Lichtquelle antreibt, die auf dem Verdrahtungssubstrat (10) montiert sind;
ein Verdrahtungsmuster (11), das sich auf dem Verdrahtungssubstrat (10) befindet und die Lichtquelle (20) und die Antriebseinheit (50) verbindet;
ein Basisteil (100), das über dem Verdrahtungsmuster (11) zwischen der Lichtquelle (20) und der Antriebseinheit (50) bereitgestellt ist; und
ein Schaltungselement (40), das in einem Bereich auf der Vorderfläche des Basisteils (100) bereitgestellt ist, wobei der Bereich das Verdrahtungsmuster (11) in einer Draufsicht überlappt, sodass ein Weg des Verdrahtungsmusters (11), der die Lichtquelle (20) und die Antriebseinheit (50) verbindet, nicht durch das Schaltungselement (40) eingeschränkt ist.

13. Optische Vorrichtung (3), umfassend:
die lichtemittierende Vorrichtung (4) nach einem der Ansprüche 1 bis 12; und
eine Lichtempfangseinheit (40), die reflektiertes Licht empfängt, das von der in der lichtemittierenden Vorrichtung (4) enthaltenen Lichtquelle emittiert und von einem zu messenden Objekt reflektiert wird,
wobei die Lichtempfangseinheit (40) ein Signal ausgibt, das einer Zeit vom Emittieren des Lichts von der Lichtquelle bis zum Empfangen des Lichts durch die Lichtempfangseinheit entspricht.

14. Informationsverarbeitungsvorrichtung (1), umfassend:
die optische Vorrichtung (3) nach Anspruch 13; und
eine Formbestimmungseinheit (81), die eine dreidimensionale Form des zu messenden Objekts basierend auf reflektiertem Licht bestimmt, das von der in der optischen Vorrichtung (3) enthaltenen Lichtquelle (20) emittiert, von dem zu messenden Objekt reflektiert und von der in der optischen Vorrichtung (3) enthaltenen Lichtempfangseinheit (40) empfangen wird.

15. Informationsverarbeitungsvorrichtung (1) nach Anspruch 14, ferner umfassend:
eine Authentifizierungsverarbeitungseinheit (91), die eine Authentifizierungsverarbeitung in Bezug auf eine Verwendung der Informationsverarbeitungsvorrichtung (1) basierend auf einem bestimmten Ergebnis der Formbestimmungseinheit (81) durchführt.

## Revendications

1. Dispositif électroluminescent (4) comprenant :
un substrat de câblage (10) ;
un élément de base (100) qui est monté sur le substrat de câblage (10) ;
une source lumineuse (20) qui est montée sur une surface avant de l'élément de base (150) ;
une unité d'entraînement (50) qui est montée sur le substrat de câblage et qui entraîne la source lumineuse (20) ;
un motif de câblage (11) qui se trouve sur le substrat de câblage (10), est relié à la source lumineuse (20) et se prolonge d'un côté de la surface arrière de l'élément de base (100) vers l'unité d'entraînement (50) ; et
un élément de circuit (40) qui est disposé dans une région sur la surface avant de l'élément de base (100) entre la source lumineuse (20) et l'unité d'entraînement (50), la région chevauchant le motif de câblage (11) dans une vue en plan, de sorte qu'un trajet du motif de câblage (11) reliant la source lumineuse (20) et l'unité d'entraînement (50) n'est pas limité par l'élément de circuit (40).

2. Dispositif électroluminescent selon la revendication 1,
dans lequel l'élément de circuit est relié électriquement au substrat de câblage, et le motif de câblage est câblé sans éviter une partie de raccordement entre l'élément de circuit et le substrat de câblage.

3. Dispositif électroluminescent (4) selon la revendication 1 ou 2,
dans lequel l'élément de circuit (40) comprend une première électrode et une seconde électrode, dans lequel la première électrode et la seconde électrode sont séparées sur deux côtés de l'élément de circuit (40) pour prendre en sandwich un motif de câblage de cathode de source lumineuse (12) disposé sur le substrat de câblage (10), et sont reliées à un motif de câblage d'anode d'élément de circuit (13) et à un motif de câblage de cathode de circuit (14).

4. Dispositif électroluminescent (4) selon l'une quelconque des revendications 1 à 3,
dans lequel la source lumineuse (20) est un réseau d'éléments électroluminescents qui comporte une première surface latérale (21A) et une deuxième surface latérale (21B) se faisant face, et une troisième surface latérale (22A) et une quatrième surface latérale (22B) se faisant face et reliant la première surface latérale (21A) et la deuxième surface latérale (21B), et
dans lequel un câblage (218) se prolongeant d'une électrode de surface supérieure du réseau d'éléments électroluminescents vers un côté extérieur du réseau d'éléments électroluminescents est disposé au moins sur un côté de la première surface latérale et de la deuxième surface latérale, l'élément de circuit est disposé sur l'élément de base (100) sur un côté de la quatrième surface latérale (22B), et le motif de câblage (11) se prolonge du côté de la quatrième surface latérale (22B) vers l'unité d'entraînement (50).

5. Dispositif électroluminescent (4) selon la revendication 4,
dans lequel le câblage (218) se prolongeant d'une électrode de surface supérieure du réseau d'éléments électroluminescents vers un côté extérieur du réseau d'éléments électroluminescents est disposé sur un côté de la troisième surface latérale (22A).

6. Dispositif électroluminescent (4) selon la revendication 4,
dans lequel un autre élément de circuit est disposé sur l'élément de base (100) sur un côté de la troisième surface latérale (22A) .

7. Dispositif électroluminescent (4) selon la revendication 6,
dans lequel au moins l'un de l'élément de circuit (40) et de l'autre élément de circuit est un élément récepteur de lumière.

8. Dispositif électroluminescent (4) selon l'une quelconque des revendications 1 à 7,
dans lequel l'élément de base (100) est un élément présentant une conductivité thermique supérieure à celle du substrat de câblage (10).

9. Dispositif électroluminescent (4) selon la revendication 8, dans lequel l'élément de base (100) sur le substrat de câblage (10) est fabriqué en céramique.

10. Dispositif électroluminescent (4) selon l'une quelconque des revendications 4 à 7,
dans lequel un élément de diffusion de lumière (30) qui diffuse, vers un extérieur, la lumière émise par la source lumineuse (20) est disposé sur un trajet d'émission du réseau d'éléments électroluminescents dans la source lumineuse (20).

11. Dispositif électroluminescent (4) selon l'une quelconque des revendications 4 à 7,
dans lequel le réseau d'éléments électroluminescents comprend une pluralité d'éléments électroluminescents reliés en parallèle les uns aux autres.

12. Dispositif électroluminescent (4), comprenant :
un substrat de câblage (10) ;
une source lumineuse (20) et une unité d'entraînement (50) entraînant la source lumineuse qui sont montées sur le substrat de câblage (10) ;
un motif de câblage (11) qui se trouve sur le substrat de câblage (10) et qui relie la source lumineuse (20) et l'unité d'entraînement (50) ;
un élément de base (100) qui est disposé à travers le motif de câblage (11) entre la source lumineuse (20) et l'unité d'entraînement (50) ; et
un élément de circuit (40) qui est disposé dans une région sur la surface avant de l'élément de base (100), la région chevauchant le motif de câblage (11) dans une vue en plan, de sorte qu'un trajet du motif de câblage (11) reliant la source lumineuse (20) et l'unité d'entraînement (50) n'est pas limité par l'élément de circuit (40).

13. Dispositif optique (3), comprenant :
le dispositif électroluminescent (4) selon l'une quelconque des revendications 1 à 12 ; et
une unité de réception de lumière (40) qui reçoit la lumière émise par le réseau d'éléments électroluminescents disposée dans le dispositif électroluminescent (4) et réfléchie par un objet à mesurer,
dans lequel l'unité de réception de lumière (40) émet un signal correspondant à un temps entre le moment où la lumière est émise par le réseau d'éléments électroluminescents et le moment où la lumière est reçue par l'unité de réception de lumière.

14. Dispositif de traitement d'informations (1) comprenant :
le dispositif optique (3) selon la revendication 13 ; et
une unité de spécification de forme (81) qui spécifie une forme tridimensionnelle de l'objet à mesurer sur la base de la lumière émise par la source lumineuse (20) disposée dans le dispositif optique (3), réfléchie par l'objet à mesurer, et reçue par l'unité de réception de lumière (40) disposée dans le dispositif optique (3).

15. Dispositif de traitement d'informations (1) selon la revendication 14, comprenant également :
une unité de traitement d'authentification (91) qui effectue un traitement d'authentification associé à l'utilisation du dispositif de traitement d'informations (1) sur la base d'un résultat de spécification de l'unité de spécification de forme (81) .
